# EUROPEAN PATENT SPECIFICATION

(11) **EP 4 033 558 B1**
(45) Date of publication and mention of the grant of the patent: **02.12.2026**
(21) Application number: 22152739.3
(22) Date of filing: 21.01.2022
(51) Int. Cl.: H10K 50/816, H10K 50/18, H10K 50/85, H10K 59/80, H10K 59/12, H10K 50/15

(54) **LIGHT-EMITTING DEVICE AND ELECTRONIC APPARATUS INCLUDING THE SAME**
LICHTEMITTIERENDE VORRICHTUNG UND ELEKTRONISCHE EINRICHTUNG DAMIT
DISPOSITIF ÉLECTROLUMINESCENT ET APPAREIL ÉLECTRONIQUE LE COMPRENANT

(30) Priority: 26.01.2021 KR 20210010800
(43) Date of publication of application: 27.07.2022
(73) Proprietor: Samsung Display Co., Ltd., Yongin-si, Gyeonggi-do 17113 (KR)
(72) Inventor: YOON, Seokgyu, 17113 Yongin-si (KR); KIM, Kyungsik, 17113 Yongin-si (KR); KIM, Soungwook, 17113 Yongin-si (KR); LEE, Jaeyong, 17113 Yongin-si (KR); CHO, Kunwook, 17113 Yongin-si (KR); KIM, Hyeongpil, 17113 Yongin-si (KR); LYU, Jaejin, 17113 Yongin-si (KR)
(74) Representative: Marks & Clerk LLP

(56) References cited:
- CN-A- 103 824 969
- JP-A- 2002 175 888
- US-A1- 2004 081 836
- US-A1- 2013 126 843
- US-A1- 2013 306 956
- US-A1- 2014 252 319
- US-A1- 2020 127 221
- US-A1- 2020 235 303
- TING ZHANG ET AL: "A CBP derivative as bipolar host for performance enhancement in phosphorescent organic light-emitting diodes", JOURNAL OF MATERIALS CHEMISTRY C, vol. 1, no. 4, 1 January 2013 (2013-01-01), pages 757 - 764, XP055191881, ISSN: 2050-7526, DOI: 10.1039/C2TC00305H
- MARKUS GANTENBEIN ET AL: "New 4,4'-Bis(9-carbazolyl)-Biphenyl Derivatives with Locked Carbazole-Biphenyl Junctions: High-Triplet State Energy Materials", CHEMISTRY OF MATERIALS, vol. 27, no. 5, 10 March 2015 (2015-03-10), pages 1772 - 1779, XP055191916, ISSN: 0897-4756, DOI: 10.1021/cm5045754
- JUNG-HWAN PARK ET AL: "New Bipolar Green Host Materials Containing Benzimidazole-Carbazole Moiety in Phosphorescent OLEDs", BULLETIN OF THE KOREAN CHEMICAL SOCIETY, vol. 32, no. 3, 20 March 2011 (2011-03-20), pages 841 - 846, XP055191890, ISSN: 0253-2964, DOI: 10.5012/bkcs.2011.32.3.841
- KROGER M ET AL: "P-type doping of organic wide band gap materials by transition metal oxides: A case-study on Molybdenum trioxide", ORGANIC ELECTRONICS, ELSEVIER, AMSTERDAM, NL, vol. 10, no. 5, 1 August 2009 (2009-08-01), pages 932 - 938, XP026235906, ISSN: 1566-1199, [retrieved on 20090510], DOI: 10.1016/J.ORGEL.2009.05.007
- NAMDAS EBINAZAR ET AL: "Simple color tuning of phosphorescent dendrimer light emitting diodes", APPLIED PHYSICS LETTERS, AMERICAN INSTITUTE OF PHYSICS, 2 HUNTINGTON QUADRANGLE, MELVILLE, NY 11747, vol. 86, no. 16, 11 April 2005 (2005-04-11), pages 161104 - 161104, XP012065079, ISSN: 0003-6951, DOI: 10.1063/1.1899256

## Description

### BACKGROUND

### 1. Field

One or more aspects of embodiments of the present disclosure relate to a light-emitting device and an electronic apparatus including the same.

### 2. Description of the Related Art

Light-emitting devices are self-emissive devices that may have a wide viewing angle, a high contrast ratio, and/or a short response time, and may show excellent or suitable characteristics in terms of luminance, driving voltage, and/or response speed.

In an example light-emitting device, a first electrode is located on a substrate, and a hole transport region, an emission layer, an electron transport region, and a second electrode are sequentially formed on the first electrode. Holes injected from the first electrode move to the emission layer through the hole transport region (e.g., a non-luminescent exciton transport region that does not contribute to light emission among excitons generated inside the emission layer), and electrons injected from the second electrode pass through the electron transport region to the emission layer. Carriers (such as holes and electrons), recombine in the emission layer to produce excitons. These excitons transition from an excited state to a ground state to thereby generate light.
US 2004/081836 A1 relates to a sputtering target, sintered article, conductive film fabricated by utilizing the same, organic EL device and substrate for use therein.
US 2013/306956 A1 relates to a flexible organic electroluminescent device and manufacturing method thereof.
US 2014/252319 A1 relates to a light emitting diode and manufacturing method thereof and display apparatus.
US 2013/126843 A1 relates to an organic EL element and production method for same.
US 2020/127221 A1 relates to a multiple hole injection structure on oxidized aluminum and applications thereof in organic luminescent devices.
CN 103 824 969 A relates to an organic electroluminescence device with multi-layer metal composite electrode.
JP 2002-175888 A relates to an organic EL element.
US 2020/235303 A1 relates to an organic light-emitting device and display apparatus including the same.

### SUMMARY

One or more aspects of embodiments of the present disclosure are directed toward a light-emitting device in which a p-doping (p-doped) layer is omitted to simplify the process and production costs are reduced, while the same level of driving voltage, efficiency and lifespan are obtained compared to a light-emitting device of the related art, color mixing due to leakage current does not occur, and color purity and color accuracy are improved.

According to embodiments of the present disclosure, the work function of an upper layer from among the layers constituting an anode is adjusted, so that without (e.g., in the absence of) a hole injection layer, smooth hole injection characteristics may be obtained.

Additional aspects will be set forth in part in the description, which follows and, in part, will be apparent from the description, or may be learned by practice of the presented embodiments of the disclosure.

According to the claimed invention, a light emitting device is as recited in claim 1.

In an embodiment, the first layer may include (e.g., consist of) the first inorganic material.

In an embodiment, a layer (e.g., one or more layers) from among the first to m^{th} layers that does not include (e.g., consist of) the first inorganic material, may include ITO, silver (Ag), or any combination thereof.

In an embodiment, i) m is 3, the third layer may include (e.g., consist of) the first inorganic material, the first layer may include ITO, and the second layer may include Ag,
ii) m is 3, the first layer and the third layer may each include (e.g., consist of) the first inorganic material, and the second layer may include Ag, or
iii) m is 4, the fourth layer may include (e.g., consist of) the first inorganic material, the first and third layers may each include ITO, and the second layer may include Ag. In an embodiment, the absolute value of the work function of the first inorganic material may be about 5.15 eV or more or about 5.20 eV or more.

In an embodiment, the first inorganic material may include WOₓ, a mixed material including In₂O₃, GeO₂ and SnO₂, a mixed material in which In₂O₃ is doped with a concentration of 5 wt% or less into at least one selected from SnO₂, MoO₃, and WOₓ, or any combination of these.

For example, the work function of WOₓ may be about -6.6 eV to about -4.6 eV.

In an embodiment, the m^{th} layer and the hole transport layer may make or form an ohmic contact (e.g., may be in ohmic or direct contact).

In an embodiment, an electron-blocking layer may be further located (e.g., included) between the hole transport layer and the emission layer.

In an embodiment, the absolute value of the HOMO energy level of the electron-blocking layer may be equal to or greater than the absolute value of the HOMO energy level of the emission layer, and may be equal to or less than the absolute value of the HOMO energy level of the hole transport layer.

In an embodiment, the electron transport region may include a buffer layer, a hole-blocking layer, an electron control layer, an electron transport layer, an electron injection layer, or any combination thereof.

For example, the electron transport region may include a hole-blocking layer, an electron transport layer, and an electron injection layer, which are sequentially arranged between the emission layer and the second electrode.

For example, the absolute value of the HOMO energy level of the hole-blocking layer may be equal to or less than the absolute value of the HOMO energy level of the emission layer, and may be equal to or less than the absolute value of the HOMO energy level of the electron transport layer.

In an embodiment, the emission layer may include a host and a dopant, and the dopant may include a phosphorescent dopant, a fluorescent dopant, or any combination thereof,
the emission layer may include quantum dots, or
the emission layer may include a delayed fluorescence material, and the delayed fluorescence material may function as a host or dopant in the emission layer.

In an embodiment, the first electrode may be the anode, and the second electrode may be the cathode.

In an embodiment, the light-emitting device may further include at least one of a first capping layer located outside the first electrode and a second capping layer located outside the second electrode, and
each of the first capping layer and the second capping layer may include a material having a refractive index of about 1.6 or more at a wavelength of about 589 nm.

In an embodiment, the interlayer may include two or more light-emitting units sequentially stacked between the first electrode and the second electrode, and one or more charge generation layers located between any neighboring two light-emitting units among the two or more emitting units.

According to the claimed invention, an electronic apparatus as recited in claim 11 is provided.

In an embodiment, the electronic apparatus may further include a thin-film transistor,
the thin-film transistor includes a source electrode and a drain electrode, and
the first electrode of the light-emitting device may be electrically connected to at least one of the source or drain electrodes of the thin-film transistor.

In an embodiment, the electronic apparatus may further include a color filter, a color conversion layer, a touch screen layer, a polarizing layer, or any combination thereof.

At least some of the above and other features of the invention are set out in the claims.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 shows a schematic cross-sectional view of a light-emitting device according to an embodiment; and
FIGS. 2 and 3 are each a cross-sectional view showing a light-emitting apparatus according to an embodiment.

### DETAILED DESCRIPTION

Reference will now be made in more detail to embodiments, selected examples of which are illustrated in the accompanying drawings, wherein like reference numerals refer to like elements throughout, and duplicative descriptions thereof may not be provided the specification. In this regard, the present embodiments may have different forms and should not be construed as being limited to the descriptions set forth herein. Accordingly, the embodiments are merely described below, by referring to the drawings, to explain aspects of the present description. As used herein, the term "and/or" includes any and all combinations of one or more of the associated listed items. Throughout the disclosure, the expression "at least one of a, b or c" may indicate only a, only b, only c, both (e.g., simultaneously) a and b, both a and c, both b and c, all of a, b, and c, or variations thereof.

It will be understood that although the terms "first," "second," etc. may be used herein to describe various components, these components should not be limited by these terms. These components are only used to distinguish one component from another.

An expression used in the singular encompasses the expression of the plural, unless it has a clearly different meaning in the context.

It will be further understood that the terms "includes," "including," "comprises" and/or "comprising" used herein specify the presence of stated features or elements, but do not preclude the presence or addition of one or more other features or elements.

Further, the use of "may" when describing embodiments of the present disclosure refers to "one or more embodiments of the present disclosure".

In the following embodiments, when various components (such as layers, films, regions, plates, etc.) are said to be "on" another component, this may include not only a case in which other components are "immediately on" the layers, films, regions, or plates, but also a case in which other components may be placed therebetween. When a component is referred to as being "directly on," another component, there are no intervening components present. Sizes of elements in the drawings may be exaggerated for convenience of explanation. In other words, because sizes and thicknesses of components in the drawings are arbitrarily illustrated for convenience of explanation, the following embodiments are not limited thereto.

In the present disclosure, the HOMO energy level and work function of materials will be described, but embodiments of the present disclosure are not limited thereto.

The HOMO energy level of the materials is measured utilizing cyclic voltammetry, and the ZIVE SP2 cyclic voltammetry apparatus (e.g., potentiostat) available from Wonatech Inc. was utilized herein. Sample solutions were prepared in electrolyte and utilized as follows, ferrocene was utilized as the reference material, and (Bu)₄NPF₆ was utilized as the electrolyte:
Sample solution of the compound to be measured: 5 X 10⁻³ M dichloromethane solution;
Ferrocene sample solution: 5 X 10⁻³ M dichloromethane solution; and
(Bu)₄NPF₆ electrolytic solution: 0.1 M acetonitrile solution.

An E_{we}-I relationship graph (e.g., voltammogram) of compounds to be measured and the reference material was obtained, and, at the point where the current rapidly increases in the graph, tangent lines were drawn, and the voltage at the point where the tangent lines meet the x-axis was recorded. The HOMO energy level of ferrocene was set to -4.8 eV, and the HOMO energy level of compounds to be measured was calculated.

The work function of a material was evaluated as follows: the material was spin-coated on an ITO substrate to form a 50-nm thin film, followed by heat treatment for 5 minutes at a temperature of 200 °C on a hot plate in air. The equipment utilized for the evaluation was equipment for ultraviolet photoelectron spectroscopy (UPS).

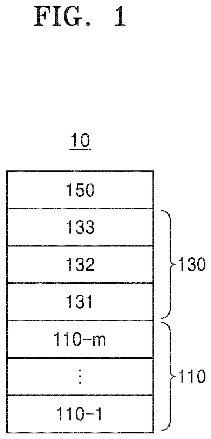

### Description of FIG. 1

FIG. 1 is a schematic cross-sectional view of a light-emitting device 10 according to an embodiment.

Hereinafter, the structure of the light-emitting device 10 according to an embodiment and a method of manufacturing the light-emitting device 10 will be described in connection with FIG. 1.

Referring to FIG. 1, a light-emitting device 10 according to an embodiment includes: a first electrode 110; a second electrode 150 facing the first electrode 110; and an interlayer 130 located between the first electrode 110 and the second electrode 150, and including an emission layer 132, a hole transport layer 131 located between the first electrode 110 and the emission layer 132, and an electron transport region 133 located between the emission layer 132 and the electron transport region 133, wherein the first electrode 110 and hole transport layer 131 are in direct contact, the first electrode 110 has a multilayer structure in which a first layer 110-1 to an m^{th} layer 110-m (m is an integer of 3 or more) are sequentially stacked, the m^{th} layer 110-m consists of a first inorganic material which is: a single material selected from GeO₂, and WOₓ (2.1≤x≤2.99); a mixed material of any combination of two or more selected from In₂O₃, GeO₂, SnO₂, MoO₃, and WOₓ; where the absolute value of the work function of the first inorganic material is greater than or equal to the absolute value of the HOMO energy level of the hole transport layer 131, and the hole transport layer 131 does not include a p-dopant.

In related art, the work function of ITO, which is mainly utilized as the anode, is not high (e.g., about 4.8 eV), so a p-doped hole injection layer is introduced between an anode and a hole transport layer. However, due to the introduction of the hole injection layer, a leakage current occurs in the lateral direction.

In the light-emitting device 10, without the inclusion (e.g., due to the exclusion) of a separate layer (for example, a p-doped hole injection layer, etc.) between the first electrode 110 and the hole transport layer 131, the first electrode 110 and the hole transport layer 131 are in direct contact. By utilizing such a structure, the occurrence of leakage current in the lateral direction due to the p-dopant and/or the like may be prevented or reduced. Furthermore, a color mixture phenomenon caused by leakage current may be prevented or reduced.

When a p-doped hole injection layer is included in a device, the hole injection characteristics may change according to the temperature of the hole injection layer, so that the operation lifespan is short at high temperature. In contrast, because a p-doped hole injection layer is excluded from the light-emitting device 10, operation lifespan at high temperature may be maintained or improved.

When the upper layer of the first electrode 110, for example, the m^{th} layer 110-m, consists of a first inorganic material which is: a single material selected from GeO₂, and WOₓ; a mixed material including any combination of two or more selected from In₂O₃, GeO₂, SnO₂, MoO₃, and WOₓ; and the work function of the first inorganic material and the HOMO energy level of the hole transport layer 131 satisfy the relationship described above, smooth hole injection may be obtained without an energy barrier, and driving voltage characteristics may be improved.

In an embodiment, the first layer 110-1 may include (e.g., consist of) the first inorganic material.

In an embodiment, i) m may be 3, the third layer may include (e.g., consist of) the first inorganic material, the first layer may include ITO, and the second layer may include Ag, ii) m may be 3, the first layer and the third layer may each include (e.g., consist of) the first inorganic material, and the second layer may include Ag, or iii) m may be 4, the fourth layer may include (e.g., consist of) the first inorganic material, the first and third layers may each include ITO, and the second layer may include Ag.

In an embodiment, the absolute value of the work function of the first inorganic material may be about 5.15 eV or more. In an embodiment, the absolute value of the work function of the first inorganic material may be about 5.20 eV or more. In an embodiment, the absolute value of the work function of the first inorganic material may be about 5.30 eV or more.

As described above, because the first inorganic material included in the m^{th} layer 110-m, which is the upper layer of the first electrode 110, satisfies the work function range described above, even when a hole transport layer 131 having a deep HOMO energy level is utilized, smooth hole injection may be realized, and due to the deep HOMO energy level of the hole transport layer, lifespan characteristics of a light-emitting device may be improved.

In an embodiment, the first inorganic material may include WOₓ; a mixed material including In₂O₃, GeO₂ and SnO₂; a mixed material in which In₂O₃ is doped with a concentration of 5 wt% or less into at least one selected from SnO₂, MoO₃, and WOₓ; or any combination of these.

In an embodiment, the m^{th} layer 110-m and the hole transport layer 131 may make an ohmic contact.

The absolute value of the highest occupied molecular orbital (HOMO) energy level of the hole transport layer 131 is about 5.15 eV or less. For example, the absolute value of the HOMO energy level of the hole transport layer 131 may be about 5.10 eV to about 5.15 eV.

In an embodiment, not according to the claimed invention, the hole transport layer 131 may include metal oxide.

For example, the metal oxide may be WO₃, MoO₃, ZnO, Cu₂O, CuO, CoO, Ga₂O₃, GeO₂, or any combination thereof, and the metal oxide may be different from (e.g., have a composition different from that of) the first inorganic material.

In an embodiment, an electron-blocking layer may be further located between the hole transport layer 131 and the emission layer 132.

For example, the absolute value of the HOMO energy level of the electron-blocking layer may be equal to or greater than the absolute value of the HOMO energy level of the emission layer 132, and may be equal to or less than the absolute value of the HOMO energy level of the hole transport layer 131.

In an embodiment, the electron transport region 133 may include a buffer layer, a hole-blocking layer, an electron control layer, an electron transport layer, an electron injection layer, or any combination thereof.

For example, the electron transport region 133 may include a hole-blocking layer, an electron transport layer, and an electron injection layer, which are sequentially arranged between the emission layer 132 and the second electrode 150.

For example, the absolute value of the HOMO energy level of the hole-blocking layer may be equal to or less than the absolute value of the HOMO energy level of the emission layer 132, and may be equal to or less than the absolute value of the HOMO energy level of the electron transport layer.

In an embodiment, the emission layer 132 may include a host and a dopant, and the dopant may include a phosphorescent dopant, a fluorescent dopant, or any combination thereof,
the emission layer 132 may include quantum dots, or
the emission layer 132 may include a delayed fluorescence material, and the delayed fluorescence material may function as a host or dopant in the emission layer 132.

In an embodiment, the first electrode 110 may be an anode and the second electrode 150 may be a cathode.

As described above, because the light-emitting device 10 does not include a hole injection layer, the structure and process (e.g., of manufacturing) can be simplified, and due to the simplification, the process costs may be reduced.

The term "interlayer" as utilized herein may refer to a single layer and/or all of a plurality of layers located between a first electrode and a second electrode of a light-emitting device.

Another aspect provides an electronic apparatus including the light-emitting device. The electronic apparatus may further include a thin-film transistor. In one or more embodiments, the electronic apparatus may further include a thin-film transistor including a source electrode and a drain electrode, and the first electrode of the light-emitting device may be electrically connected to the source electrode or the drain electrode. In an embodiment, the electronic apparatus may further include a color filter, a color conversion layer, a touch screen layer, a polarizing layer, or any combination thereof. The electronic apparatus may be the same as described in the present specification.

### Description of FIG. 1

FIG. 1 is a schematic cross-sectional view of a light-emitting device 10 according to an embodiment. The light-emitting device 10 includes a first electrode 110, an interlayer 130, and a second electrode 150.

Hereinafter, the structure of the light-emitting device 10 according to an embodiment and a method of manufacturing the light-emitting device 10 will be described in connection with FIG. 1.

### First electrode 110

In FIG. 1, a substrate may be additionally located under the first electrode 110 or above the second electrode 150. As the substrate, a glass substrate and/or a plastic substrate may be utilized. In one or more embodiments, the substrate may be a flexible substrate, and may include plastics with excellent or suitable heat resistance and durability (such as polyimide, polyethylene terephthalate (PET), polycarbonate, polyethylene naphthalate, polyarylate (PAR), polyetherimide, or any combination thereof).

The first electrode 110 may be formed by, for example, depositing or sputtering a material for forming the first electrode 110 on the substrate.

The first electrode 110 may be the same as described above.

### Interlayer 130

The interlayer 130 may be located on the first electrode 110. The interlayer 130 may include an emission layer 132.

The interlayer 130 may further include a hole transport region located between the first electrode 110 and the emission layer 132 and an electron transport region located between the emission layer 132 and the second electrode 150.

The interlayer 130 may further include, in addition to one or more suitable organic materials, metal-containing compounds (such as organometallic compounds), inorganic materials (such as quantum dots), and/or the like.

In one or more embodiments, the interlayer 130 may include: i) two or more light-emitting units sequentially stacked between the first electrode 110 and the second electrode 150, and ii) one or more charge generation layer located between any neighboring two light-emitting units among the two or more emitting units. When the interlayer 130 includes emitting units and a charge generation layer as described above, the light-emitting device 10 may be a tandem light-emitting device.

### Hole transport region in interlayer 130

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole transport layer (HTL) 131, an emission auxiliary layer, an electron-blocking layer (EBL), or any combination thereof.

In an embodiment, the hole transport region may have the multi-layered structure of hole transport layer 131/emission auxiliary layer, hole transport layer 131/emission auxiliary layer, or hole transport layer 131/electron-blocking layer, which are sequentially stacked in this stated order on the first electrode 110.

The hole transport region may include a compound represented by Formula 201, a compound represented by Formula 202, or any combination thereof: 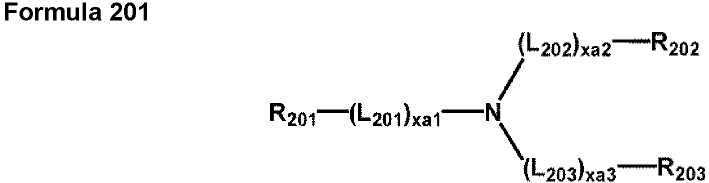 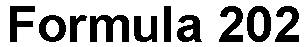 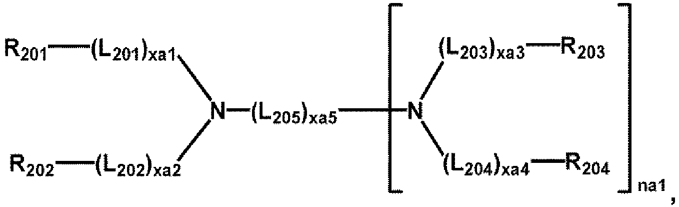 wherein, in Formulae 201 and 202,
L₂₀₁ to L₂₀₄ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
L₂₀₅ may be *-O-*', *-S-*', *-N(Q₂₀₁)-*', a C₁-C₂₀ (e.g. C₁-C₁₀) alkylene group unsubstituted or substituted with at least one R₁₀ₐ, a C₂-C₂₀ (e.g. C₂-C₂₀) alkenylene group unsubstituted or substituted with at least one R₁₀ₐ, a C₃-C₆₀ (e.g. C₃-C₃₀) carbocyclic group unsubstituted or substituted with at least one R₁₀ₐ, or a C₁-C₆₀ (e.g. C₁-C₂₀) heterocyclic group unsubstituted or substituted with at least one R₁₀ₐ,
xa1 to xa4 may each independently be an integer selected from 0 to 5,
xa5 may be an integer selected from 1 to 10,
R₂₀₁ to R₂₀₄ and Q₂₀₁ may each independently be a C₃-C₆₀ (*e.g*. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
R₂₀₁ and R₂₀₂ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (e.g. C₈-C₃₀) polycyclic group (for example, a carbazole group and/or the like) unsubstituted or substituted with at least one R₁₀ₐ (for example, Compound HT16),
R₂₀₃ and R₂₀₄ may optionally be linked to each other, via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (*e.g*. C₈-C₃₀) polycyclic group unsubstituted or substituted with at least one R₁₀ₐ, and
na1 may be an integer selected from 1 to 4.

In one or more embodiments, each of Formulae 201 and 202 may include at least one of the groups represented by Formulae CY201 to CY217 (e.g., as one of groups R₂₀₁ to R₂₀₄):

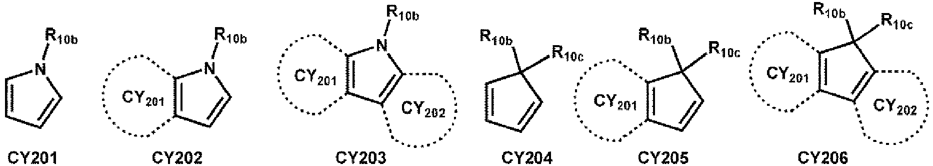

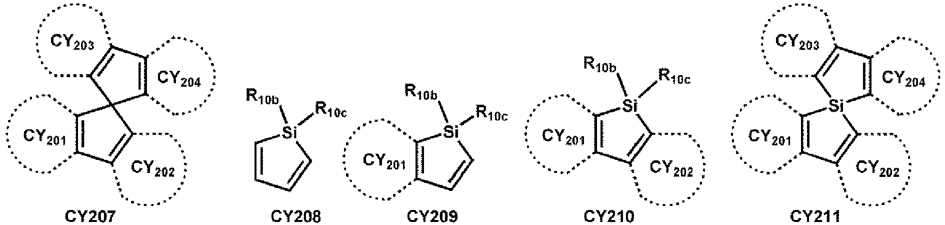

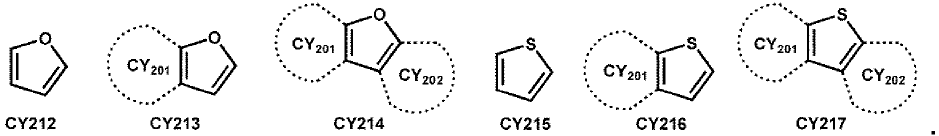

R_{10b} and R_{10c} in Formulae CY201 to CY217 may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, ring CY₂₀₁ to ring CY₂₀₄ in Formulae CY201 to CY217 may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, xa1 in Formula 201 is 1, R₂₀₁ may be a group represented by one of Formulae CY201 to CY203, xa2 may be 0, and R₂₀₂ may be a group represented by one of Formulae CY204 to CY207.

In one or more embodiments, each of Formulae 201 and 202 may not include a group represented by one of Formulae CY201 to CY203.

In one or more embodiments, each of Formulae 201 and 202 may not include a group represented by one of Formulae CY201 to CY203, and may include at least one of the groups represented by Formulae CY204 to CY217.

In one or more embodiments, each of Formulae 201 and 202 may not include a group represented by one of Formulae CY201 to CY217.

In an embodiment, the hole-transporting region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzene sulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), or any combination thereof:

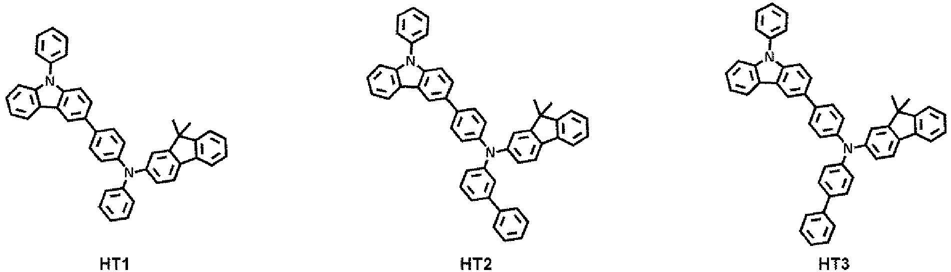

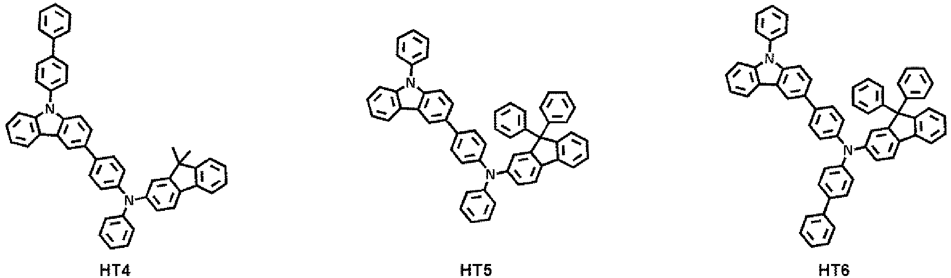

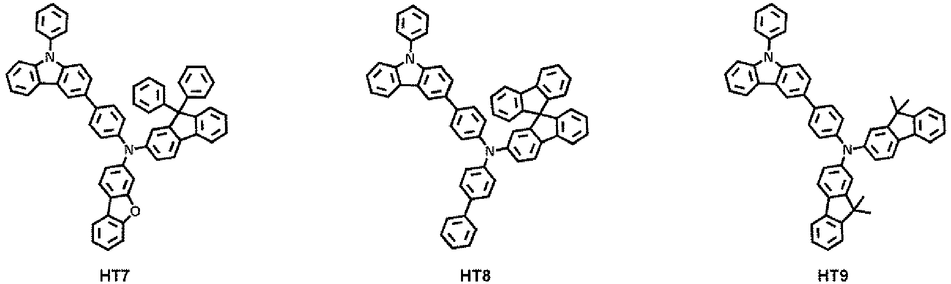

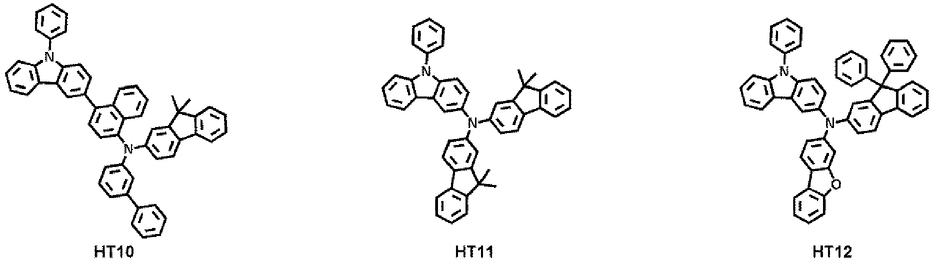

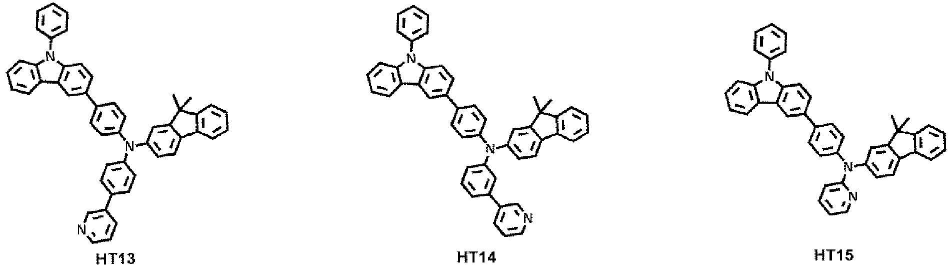

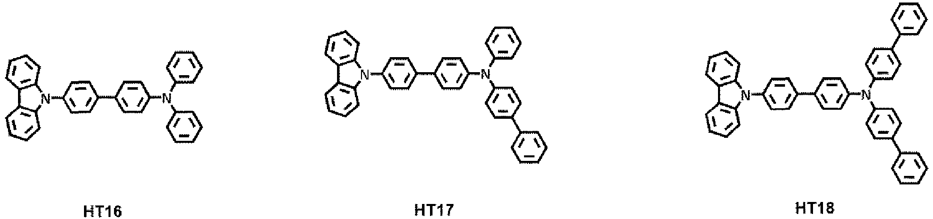

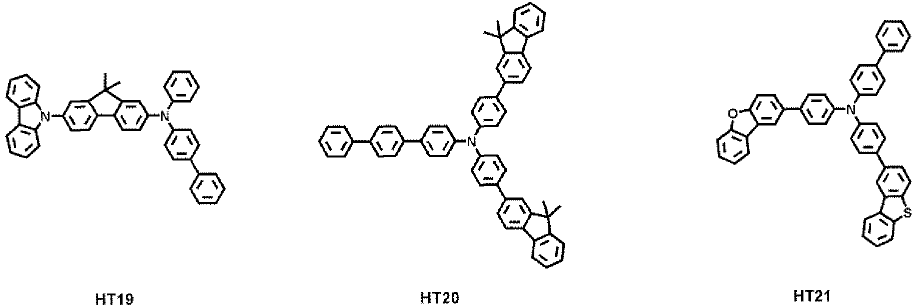

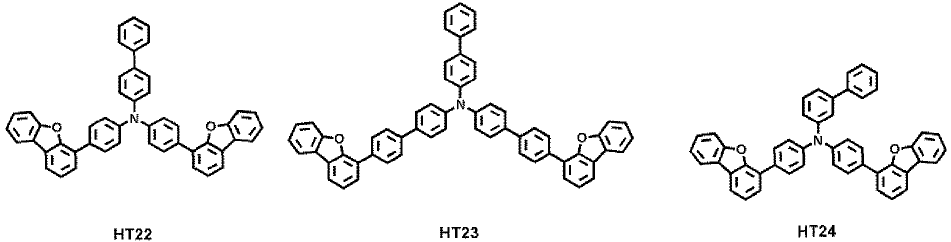

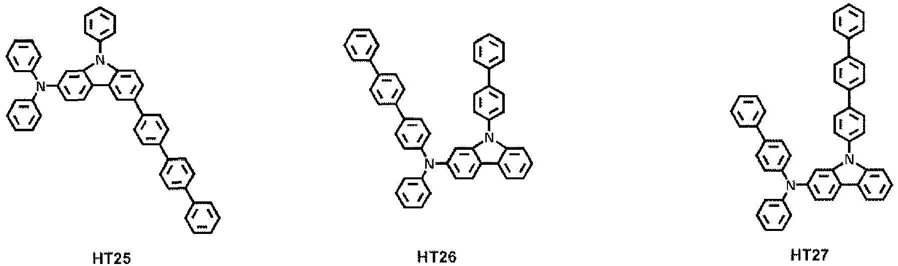

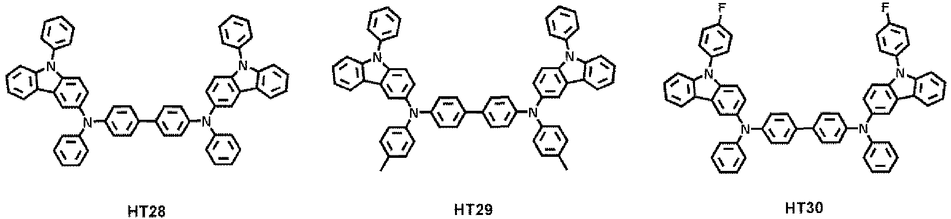

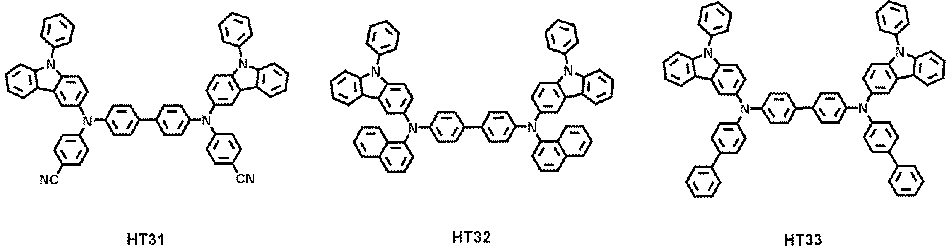

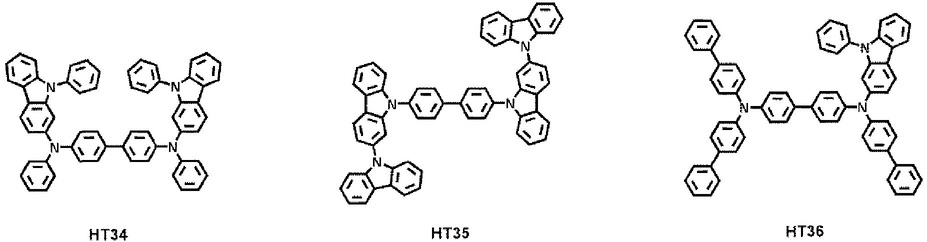

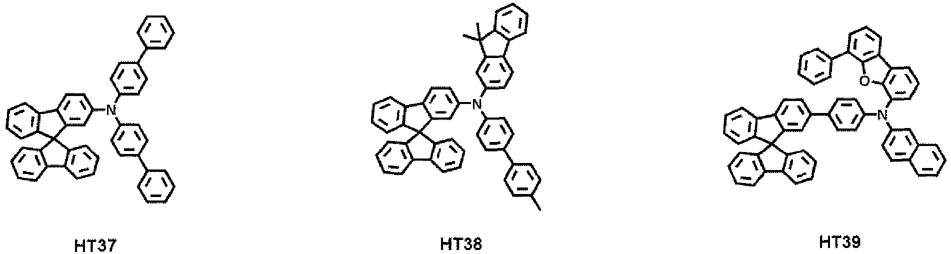

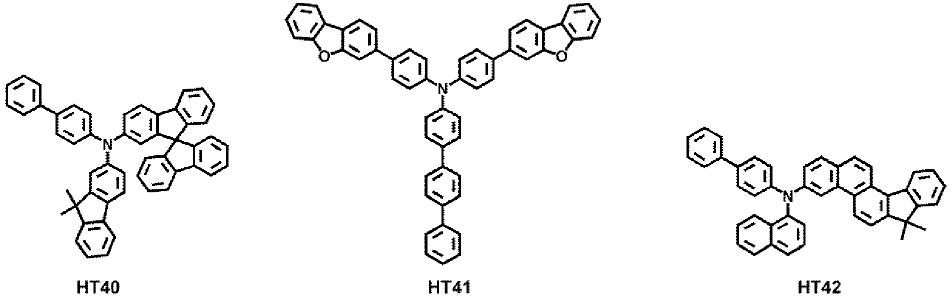

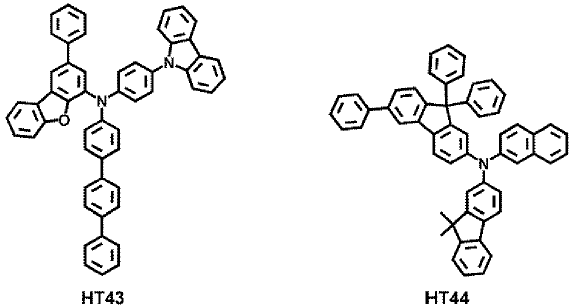

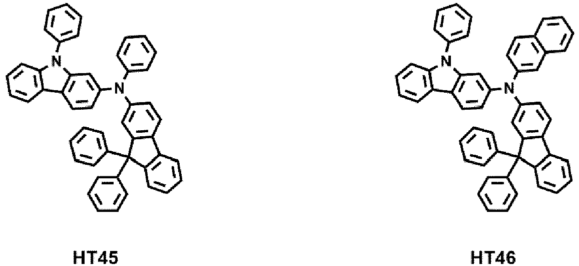

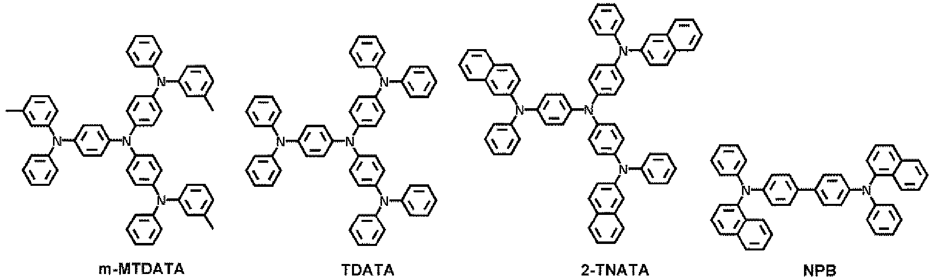

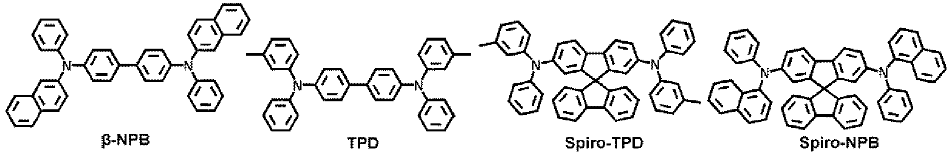

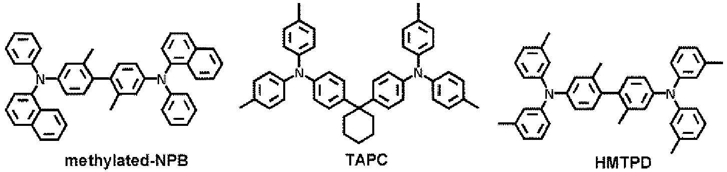

A thickness of the hole transport region may be in a range of about 50 Å to about 10,000 Å, for example, about 100 Å to about 4,000 Å. When the hole transport region includes a hole transport layer 131, the thickness of the hole transport layer 131 may be about 50 Å to about 2,000 Å, for example, about 100 Å to about 1,500 Å. When the thicknesses of the hole transport region and the hole transport layer 131 are within the range described above, satisfactory hole transportation characteristics may be obtained without a substantial increase in driving voltage.

The emission auxiliary layer may increase the light-emission efficiency a device by compensating for an optical resonance distance of the wavelength of light emitted by an emission layer, and the electron-blocking layer may block or reduce the leakage of electrons from an emission layer to a hole-transporting region. Materials that may be included in the hole-transporting region may be included in the emission auxiliary layer and the electron-blocking layer.

### Emission layer 132 in interlayer 130

When the light-emitting device 10 is a full-color light-emitting device, the emission layer 132 may be patterned into a red emission layer, a green emission layer, and/or a blue emission layer, according to a subpixel. In one or more embodiments, the emission layer 132 may have a stacked structure of two or more layers of a red emission layer, a green emission layer, and a blue emission layer, in which the two or more layers may contact each other or may be separated from each other. In one or more embodiments, the emission layer may include two or more materials of a red light-emitting material, a green light-emitting material, and a blue light-emitting material, in which the two or more materials are mixed with each other in a single layer to emit white light.

The emission layer 132 may include a host and a dopant. The dopant may include a phosphorescent dopant, a fluorescent dopant, or any combination thereof.

The amount of the dopant in the emission layer 132 may be about 0.01 to about 15 parts by weight based on 100 parts by weight of the host.

In one or more embodiments, the emission layer 132 may include a quantum dot.

In some embodiments, the emission layer 132 may include a delayed fluorescence material. The delayed fluorescence material may function as a host or a dopant in the emission layer 132.

A thickness of the emission layer 132 may be in a range of about 100 Å to about 1,000 Å, for example, about 200 Å to about 600 Å. When the thickness of the emission layer 132 is within these ranges, excellent or suitable luminescence characteristics may be obtained without a substantial increase in driving voltage.

### Host

In one or more embodiments, the host may include a compound represented by Formula 301:

**Formula 301** [Ar₃₀₁]_{xb11}-[(L₃₀₁)_{xb1}-R₃₀₁]_{xb21}.

In Formula 301,
Ar₃₀₁ and L₃₀₁ may each independently be a C₃-C₆₀ (e.g. C₃-C₃₀) carbocyclic group unsubstituted or substituted with at least one R₁₀ₐ or a C₁-C₆₀ (e.g. C₁-C₂₀) heterocyclic group unsubstituted or substituted with at least one R₁₀ₐ,
xb11 may be 1, 2, or 3,
xb1 may be an integer selected from 0 to 5,
R₃₀₁ may be hydrogen, deuterium, -F, -Cl, -Br, -I, a hydroxyl group, a cyano group, a nitro group, a C₁-C₆₀ (*e.g*. C₁-C₂₀) alkyl group unsubstituted or substituted with at least one R₁₀ₐ, a C₂-C₆₀ (*e.g*. C₂-C₂₀) alkenyl group unsubstituted or substituted with at least one R₁₀ₐ, a C₂-C₆₀ (*e.g*. C₂-C₂₀) alkynyl group unsubstituted or substituted with at least one R₁₀ₐ, a C₁-C₆₀ (*e.g*. C₁-C₂₀) alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R_{10a,}-Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), or -P(=O)(Q₃₀₁)(Q₃₀₂),
xb21 may be an integer selected from 1 to 5, and
Q₃₀₁ to Q₃₀₃ may each independently be the same as described in connection with Q₁.

For example, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or any combination thereof:

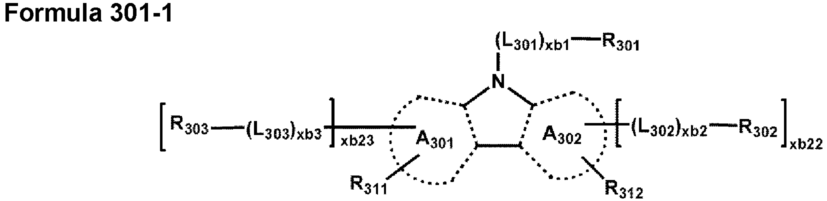

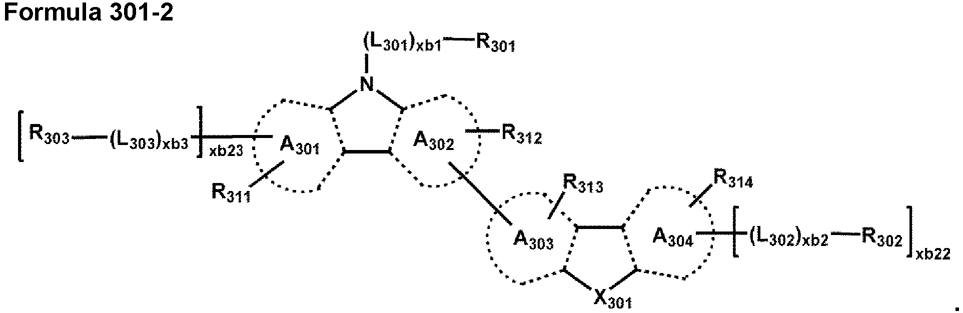

In Formulae 301-1 and 301-2,
ring A₃₀₁ to ring A₃₀₄ may each independently be a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each independently be the same as described in the present specification,
L₃₀₂ to L₃₀₄ may each independently be the same as described in connection with L₃₀₁,
xb2 to xb4 may each independently be the same as described in connection with xb1, and
R₃₀₂ to R₃₀₅ and R₃₁₁ to R₃₁₄ may each independently be the same as described in connection with R₃₀₁.

In one or more embodiments, the host may include an alkali earth metal complex, a post-transition metal complex, or a combination thereof. In one or more embodiments, the host may include a Be complex (for example, Compound H55), an Mg complex, a Zn complex, or a combination thereof.

In an embodiment, the host may include one of Compounds H1 to H124, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

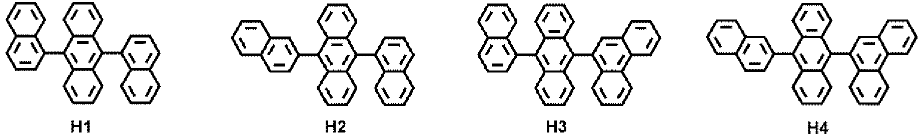

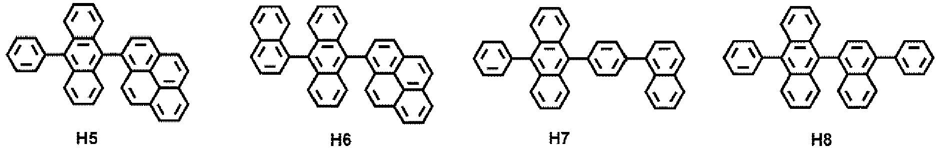

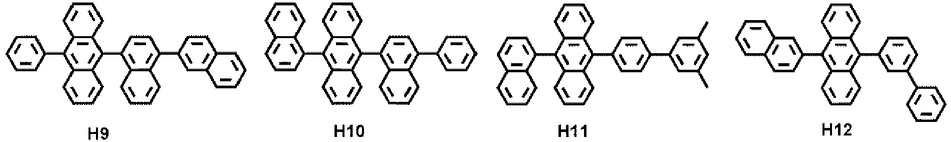

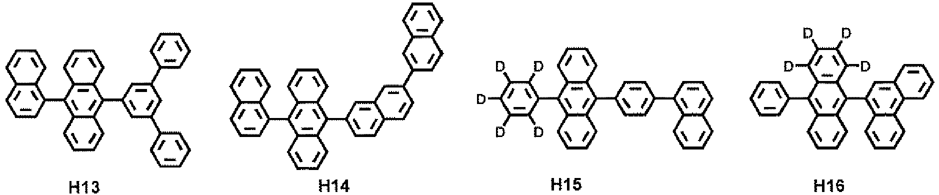

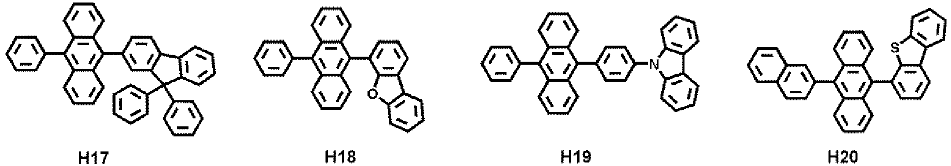

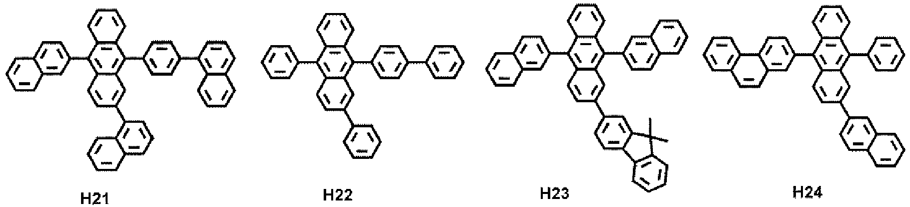

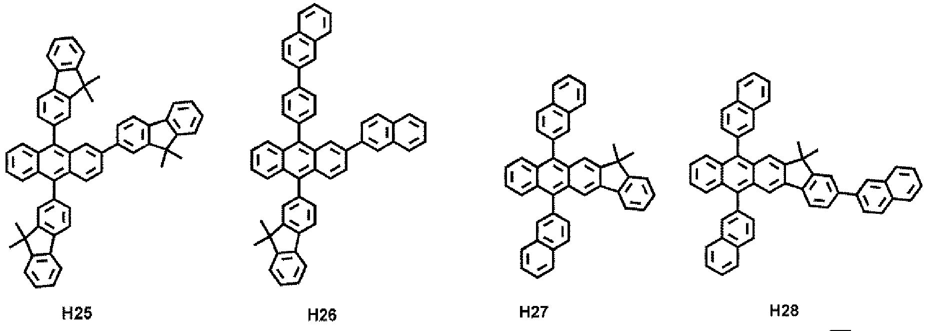

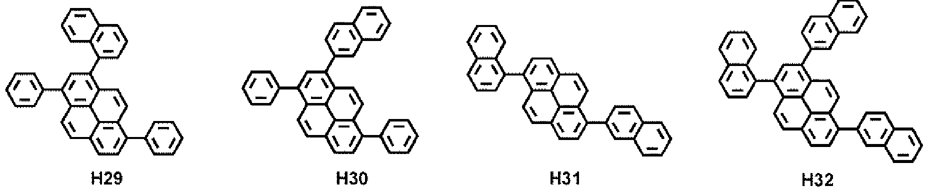

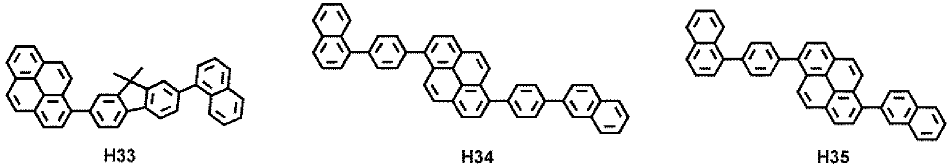

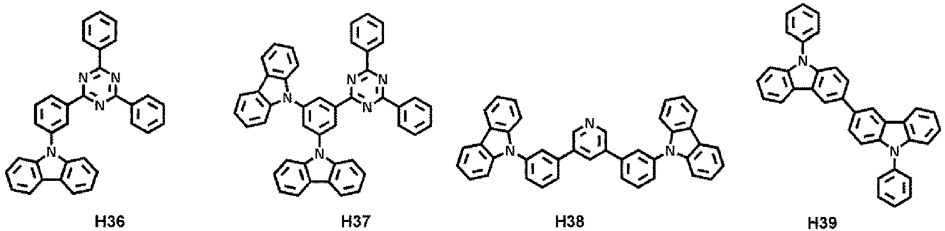

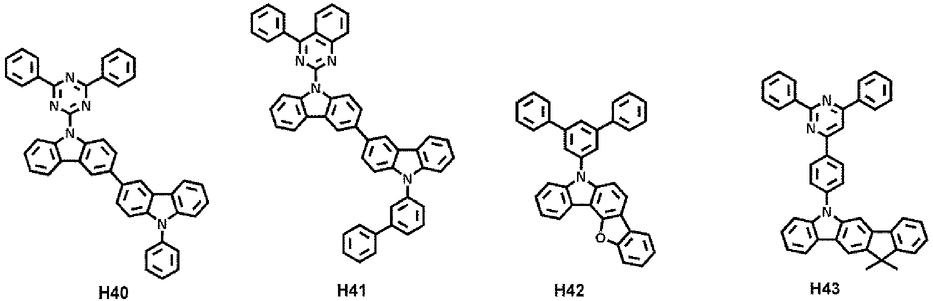

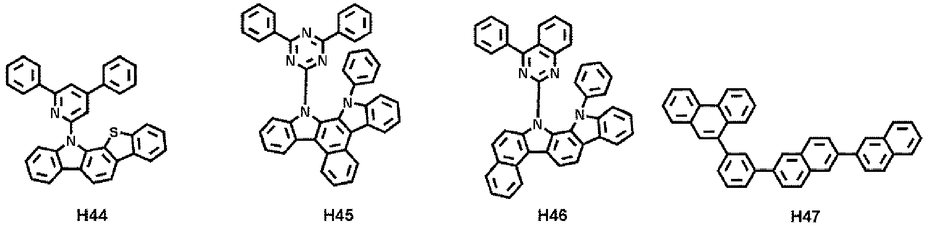

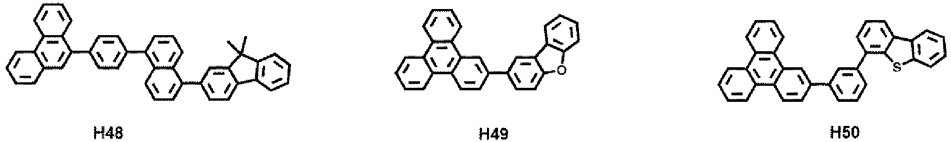

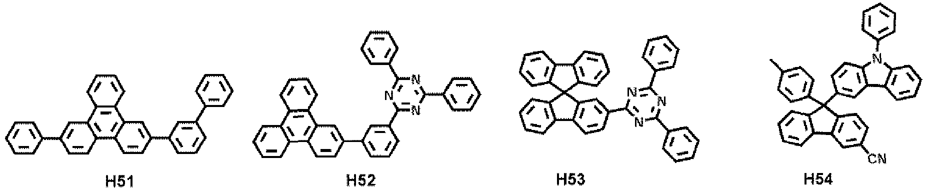

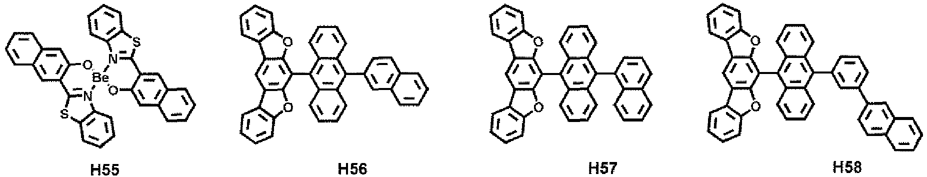

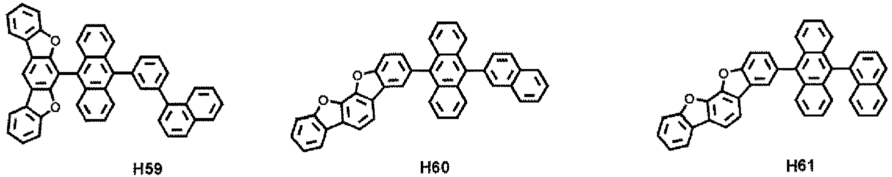

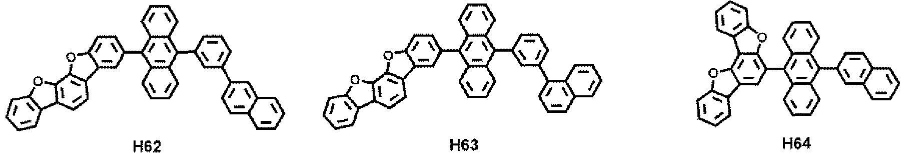

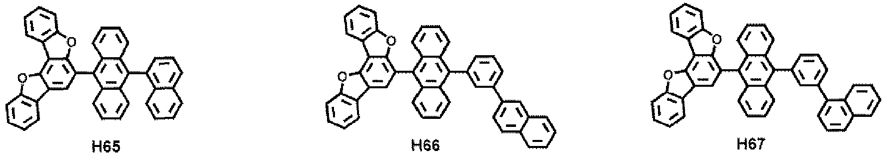

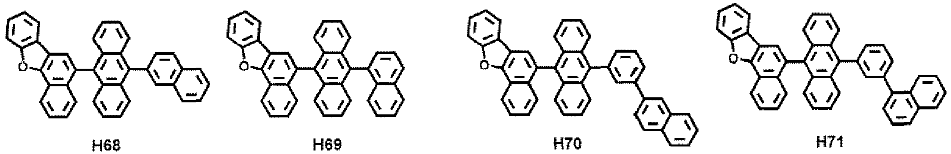

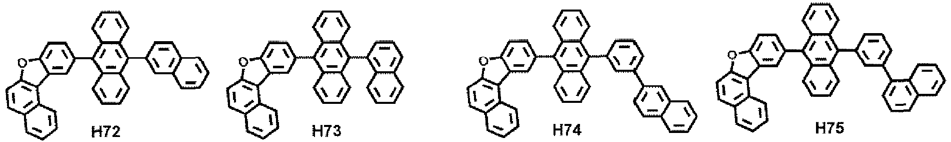

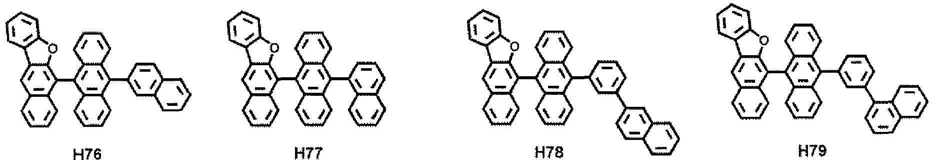

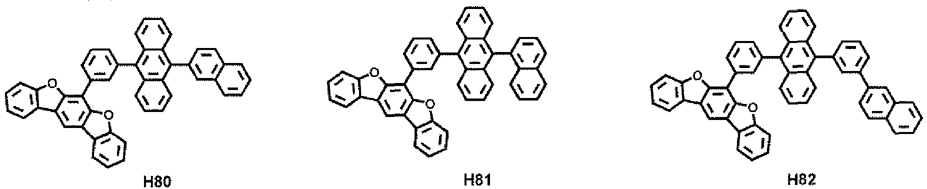

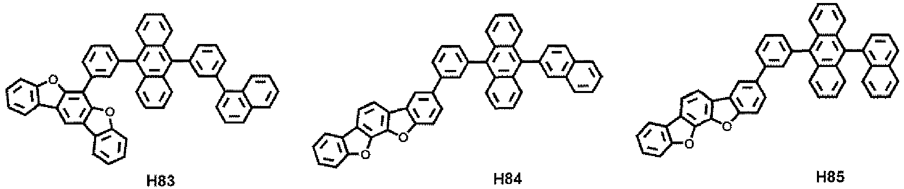

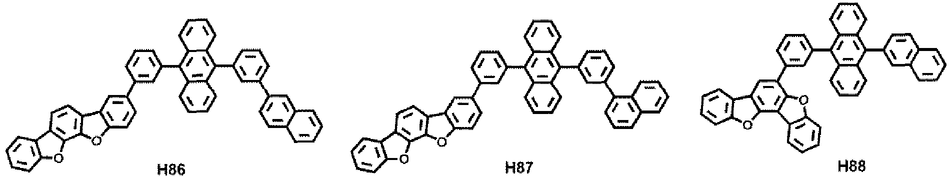

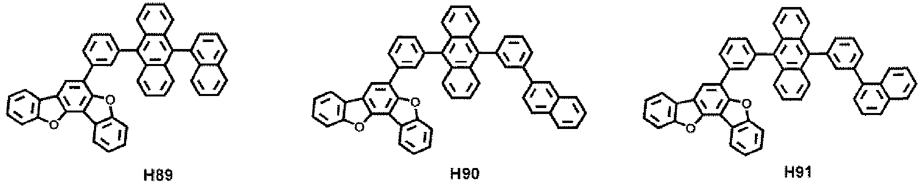

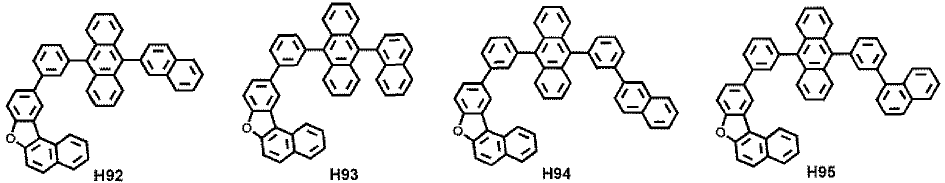

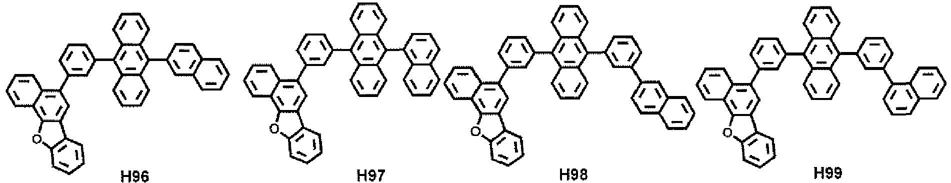

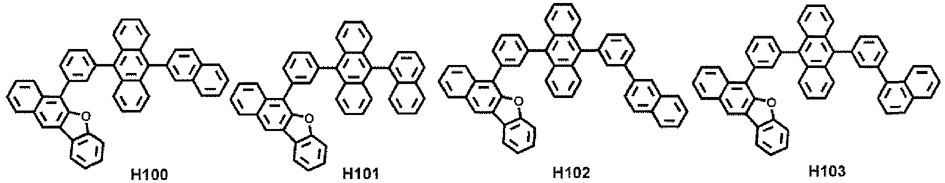

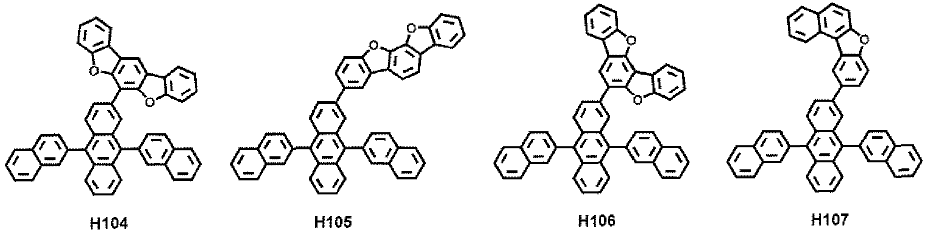

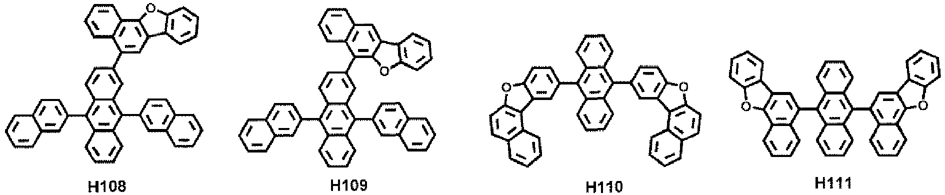

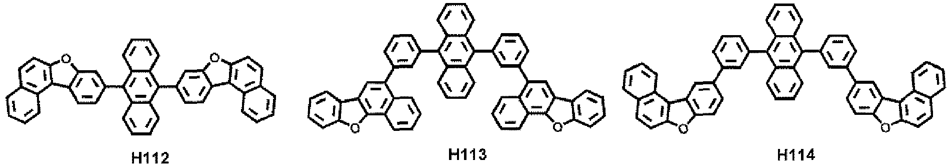

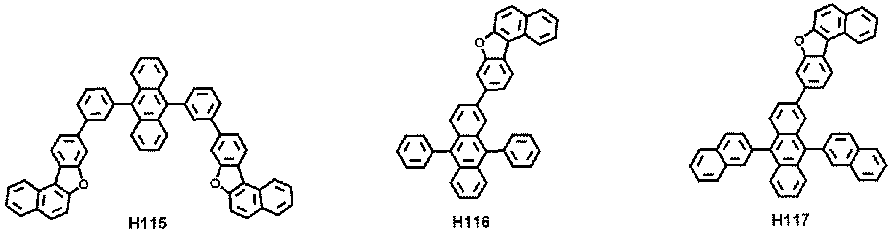

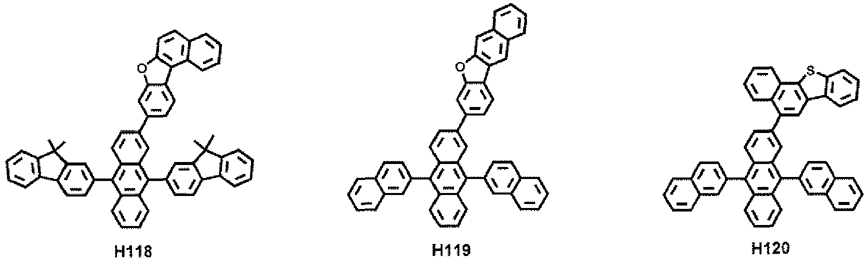

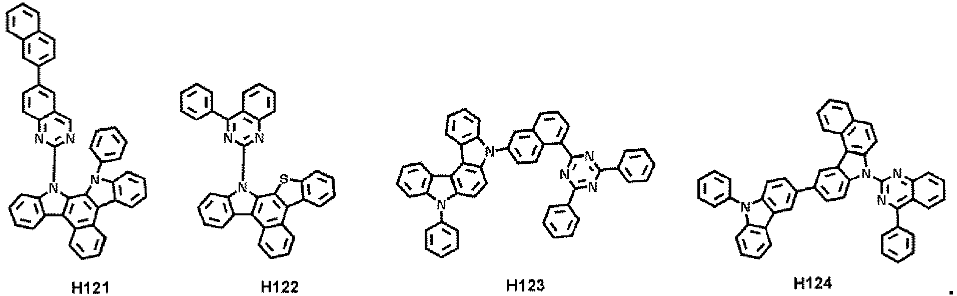

### Phosphorescent dopant

In one or more embodiments, the phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electronically neutral.

For example, the phosphorescent dopant may include an organometallic compound represented by Formula 401:

**Formula 401** M(L₄₀₁)_{xc1}(L₄₀₂)_{xc2}

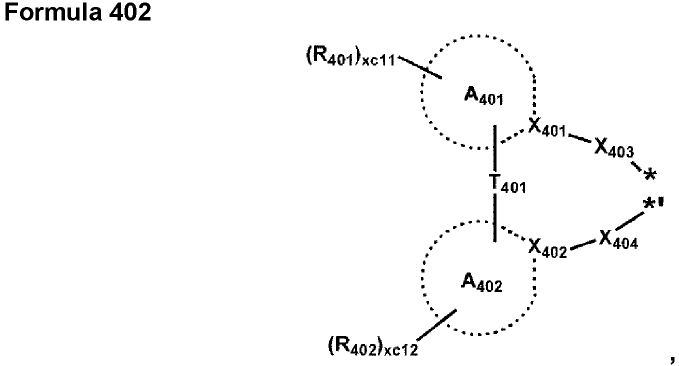

wherein, in Formulae 401 and 402,
M may be transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein when xc1 is two or more, two or more of L₄₀₁(s) may be identical to or different from each other,
L₄₀₂ may be an organic ligand, and xc2 may be 0, 1, 2, 3, or 4, and when xc2 is 2 or more, two or more L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ (*e.g*. C₃-C₃₀) carbocyclic group or a C₁-C₆₀ (*e.g*. C₁-C₂₀) heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordination bond), O, S, N(Q₄₁₃), B(Q₄₁₃), P(Q₄₁₃), C(Q₄₁₃)(Q₄₁₄), or Si(Q₄₁₃)(Q₄₁₄),
Q₄₁₁ to Q₄₁₄ may each independently be the same as described in connection with Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each independently be the same as described in connection with Q₁,
xc11 and xc12 may each independently be an integer selected from 0 to 10,
* and *' in Formula 402 each indicate a binding site to M in Formula 401.

For example, in Formula 402, i) X₄₀₁ is nitrogen, and X₄₀₂ is carbon, or ii) each of X₄₀₁ and X₄₀₂ is nitrogen.

In one or more embodiments, when xc1 in Formula 401 is 2 or more, two ring A₄₀₁ in two or more of L₄₀₁(s) may be optionally linked to each other via T₄₀₂ (which is a linking group), and two ring A₄₀₂ may optionally be linked to each other via T₄₀₃, (which is a linking group) (see e.g., Compounds PD1 to PD4 and PD7). T₄₀₂ and T₄₀₃ may each independently be the same as described in connection with T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O), an isonitrile group, -CN group, a phosphorus group (for example, a phosphine group, a phosphite group, etc.), or any combination thereof.

The phosphorescent dopant may include, for example, one of compounds PD1 to PD25, or any combination thereof:

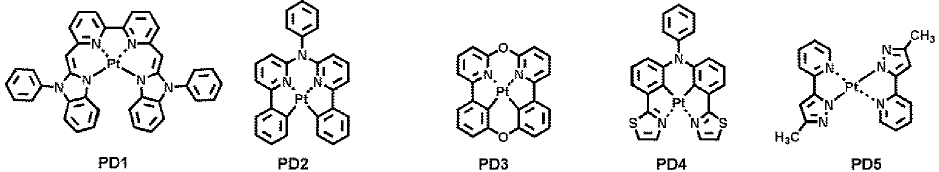

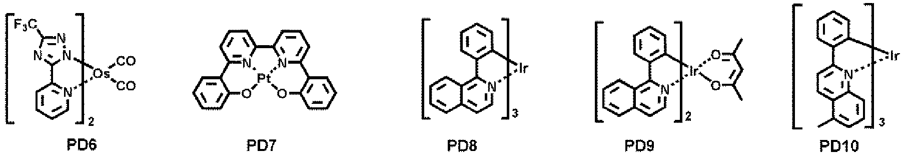

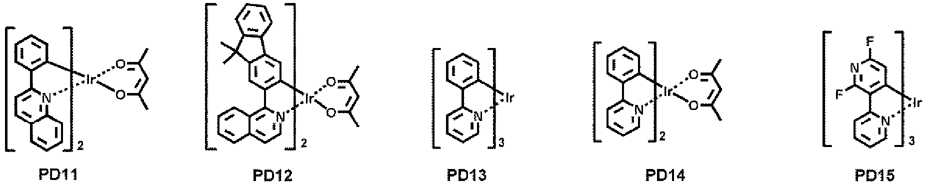

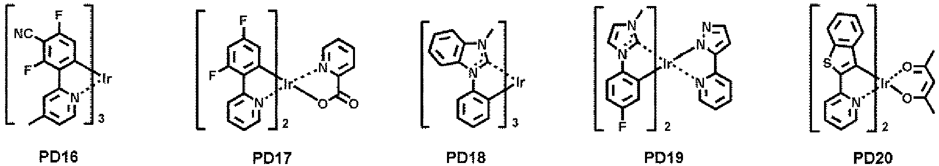

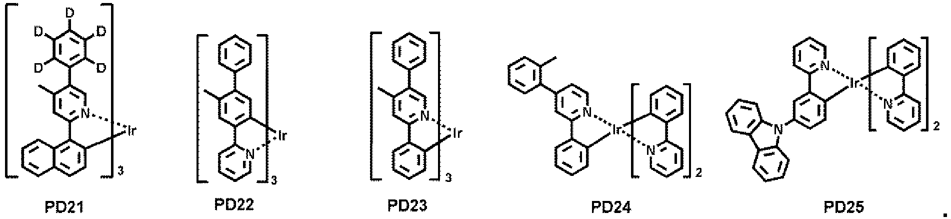

### Fluorescent dopant

The fluorescent dopant may include an amine group-containing compound, a styryl group-containing compound, or any combination thereof.

In one or more embodiments, the fluorescent dopant may include a compound represented by Formula 501: 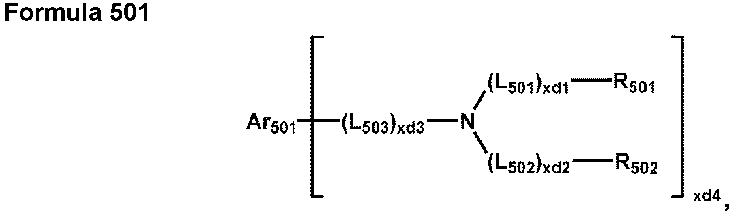 wherein, in Formula 501,
Ar₅₀₁, L₅₀₁ to L₅₀₃, R₅₀₁, and R₅₀₂ may each independently be a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
xd1 to xd3 may each independently be 0, 1, 2, or 3, and
xd4 may be 1, 2, 3, 4, 5, or 6.

In one or more embodiments, Ar₅₀₁ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

In one or more embodiments, the fluorescent dopant may include: one of Compounds FD1 to FD36; DPVBi; DPAVBi; or any combination thereof:

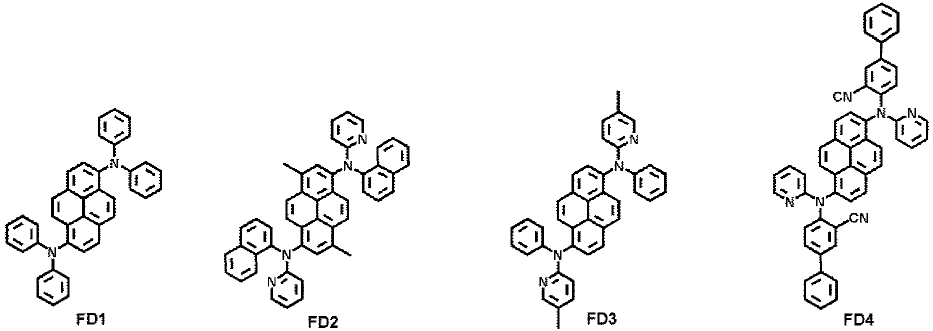

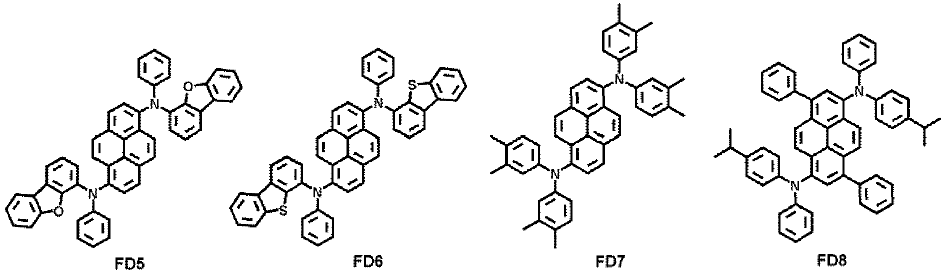

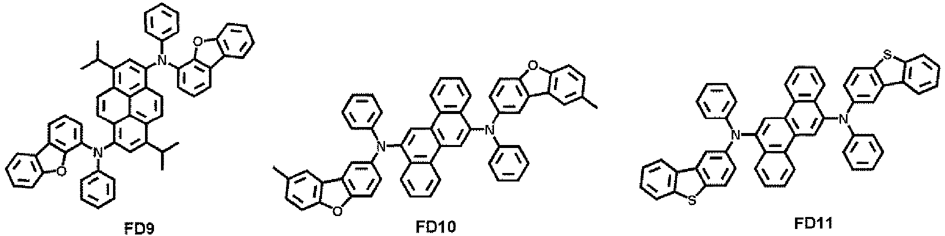

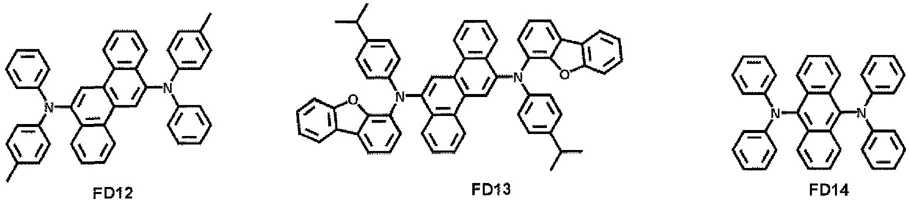

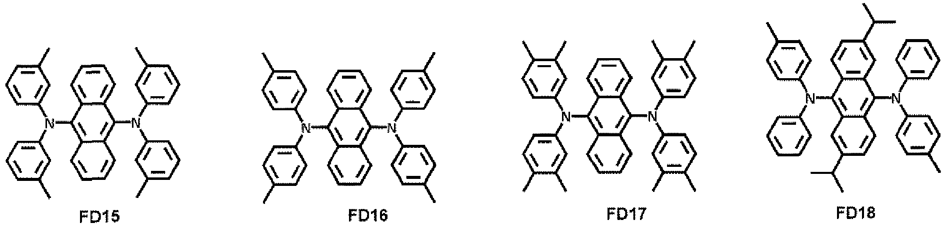

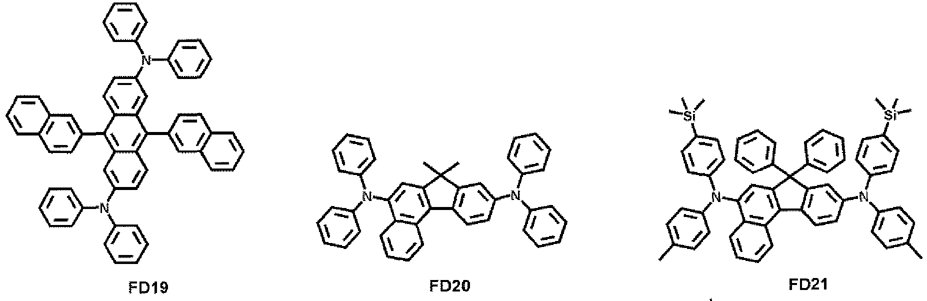

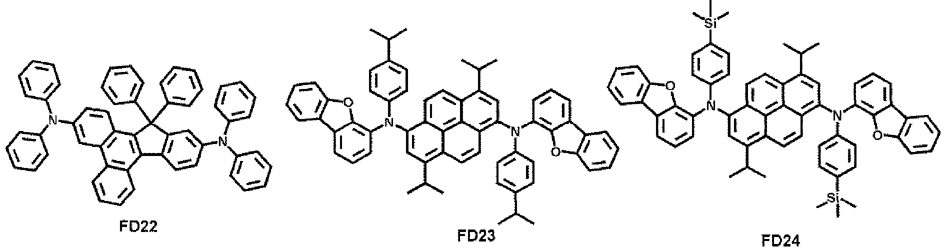

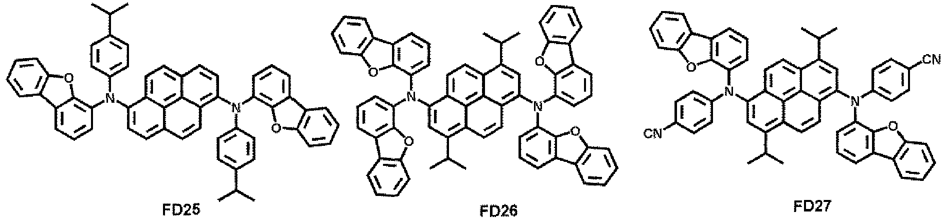

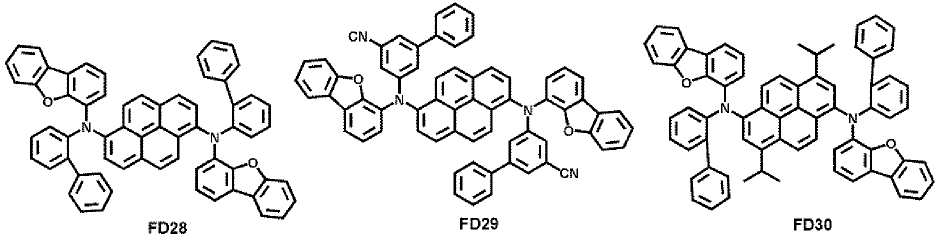

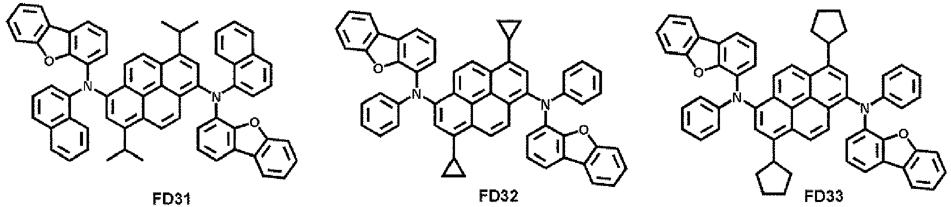

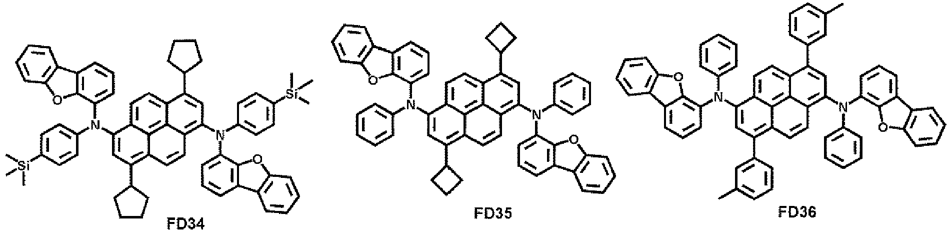

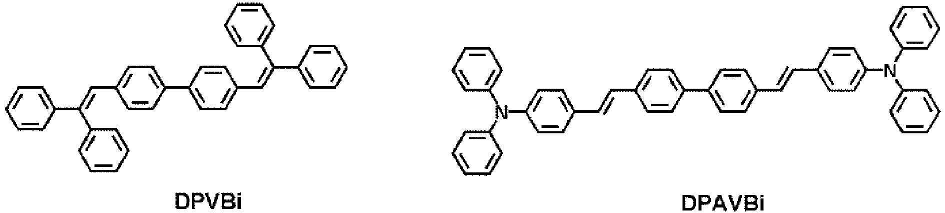

### Delayed fluorescence material

The emission layer 132 may include a delayed fluorescence material.

In the present specification, the delayed fluorescence material may be selected from compounds capable of emitting delayed fluorescence based on a delayed fluorescence emission mechanism.

The delayed fluorescence material included in the emission layer 132 may function as a host or a dopant depending on the type or kind of other materials included in the emission layer 132.

In one or more embodiments, the difference between the triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescent material and the singlet energy level (eV) of the delayed fluorescent material satisfies the above-described range, up-conversion from the triplet state to the singlet state of the delayed fluorescent materials may effectively occur, and thus, the emission efficiency of the light-emitting device 10 may be improved.

In one or more embodiments, the delayed fluorescence material may be or include: i) a material including at least one electron donor (for example, a π electron-rich C₃-C₆₀ (*e.g*. C₃-C₃₀) cyclic group, such as a carbazole group) and at least one electron acceptor (for example, a sulfoxide group, a cyano group, or a π electron-deficient nitrogen-containing C₁-C₆₀ (*e.g*. C₁-C₃₀) cyclic group), and ii) a material including a C₈-C₆₀ (*e.g*. C₈-C₃₀) polycyclic group in which two or more cyclic groups are condensed while sharing a boron (B) atom.

In one or more embodiments, the delayed fluorescence material may include at least one of the following compounds DF1 to DF9:

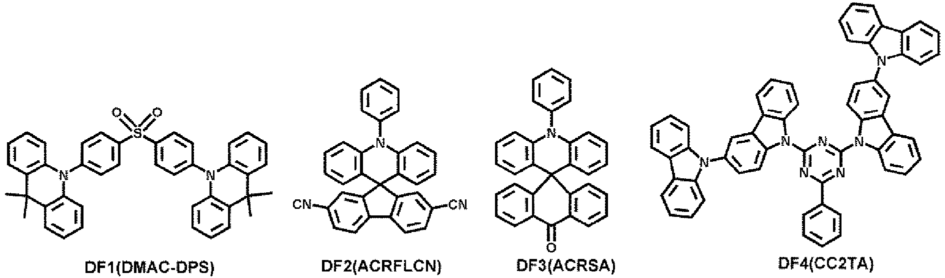

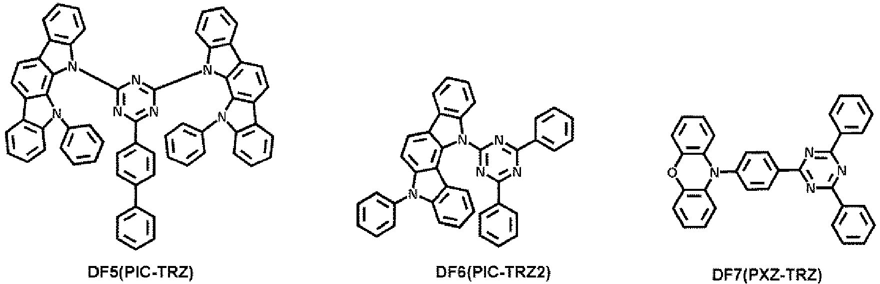

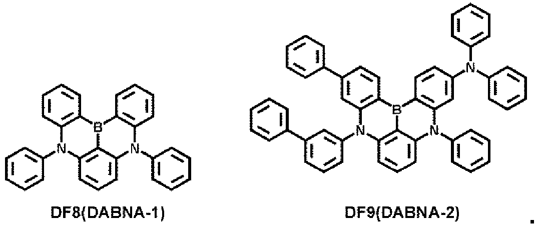

### Quantum dot

In one or more embodiments, the emission layer 132 may include a quantum dot(s).

In the present specification, the term "quantum dot" refers to a crystal of a semiconductor compound, and may include any material capable of emitting light of one or more suitable emission wavelengths corresponding to the size of the crystal.

A diameter of the quantum dot may be, for example, in a range of about 1 nm to about 10 nm.

The quantum dot may be synthesized by a wet chemical process, a metal organic chemical vapor deposition process, a molecular beam epitaxy process, or any suitable process similar thereto.

In an example wet chemical process, a precursor material is mixed with an organic solvent to grow a quantum dot particle crystal. As the crystal grows, the organic solvent naturally functions as a dispersant coordinated to the surface of the quantum dot crystal, and thereby controls the growth of the crystal so that the growth of quantum dot particles can be controlled or selected according to a process that is more easily performed than vapor deposition methods (such as metal organic chemical vapor deposition (MOCVD) or molecular beam epitaxy (MBE)), and has lower costs.

The quantum dot may include a Group II-VI semiconductor compound, a Group III-V semiconductor compound, a Group III-VI semiconductor compound, a Group I-III-VI semiconductor compound, a Group IV-VI semiconductor compound, a Group IV element or compound; or any combination thereof.

Examples of the Group II-VI semiconductor compound may include a binary compound (such as CdSe, CdTe, ZnS, ZnSe, ZnTe, ZnO, HgS, HgSe, HgTe, MgSe, and/or MgS); a ternary compound (such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS); a quaternary compound (such as CdZnSeS, CdZnSeTe, CdZnSTe, CdHgSeS, CdHgSeTe, CdHgSTe, HgZnSeS, HgZnSeTe, and/or HgZnSTe); or any combination thereof.

Examples of the Group III-V semiconductor compound may include a binary compound (such as GaN, GaP, GaAs, GaSb, AIN, AlP, AlAs, AlSb, InN, InP, InAs, InSb, and/or the like); a ternary compound (such as GaNP, GaNAs, GaNSb, GaPAs, GaPSb, AINP, AlNAs, AlNSb, AlPAs, AlPSb, InGaP, InNP, InAlP, InNAs, InNSb, InPAs, InPSb, and/or the like); a quaternary compound (such as GaAlNP, GaAINAs, GaAINSb, GaAlPAs, GaAlPSb, GaInNP, GaInNAs, GaInNSb, GaInPAs, GaInPSb, InAlNP, InAINAs, InAlNSb, InAIPAs, InAIPSb, and/or the like); or any combination thereof. In some embodiments, the Group III-V semiconductor compound may further include Group II elements. Examples of the Groups III-V further including Group II elements may include InZnP, InGaZnP, InAlZnP, etc.

Examples of the Group III-VI semiconductor compound may include a binary compound (such as GaS, GaSe, Ga₂Se₃, GaTe, InS, InSe, In₂S₃, In₂Se₃, and/or InTe); a ternary compound (such as InGaS₃, and/or InGaSe₃); and any combination thereof.

Examples of the Group I-III-VI semiconductor compound may include a ternary compound (such as AgInS, AgInS₂, CuInS, CuInS₂, CuGaO₂, AgGaO₂, and/or AgAlO₂); or any combination thereof.

Examples of the Group IV-VI semiconductor compound may include a binary compound (such as SnS, SnSe, SnTe, PbS, PbSe, PbTe, and/or the like); a ternary compound (such as SnSeS, SnSeTe, SnSTe, PbSeS, PbSeTe, PbSTe, SnPbS, SnPbSe, SnPbTe, and/or the like); a quaternary compound (such as SnPbSSe, SnPbSeTe, SnPbSTe, and/or the like); or any combination thereof.

The Group IV element or compound may include a single element compound (such as Si and/or Ge); a binary compound (such as SiC and/or SiGe); or any combination thereof.

Each element included in a multi-element compound (such as the binary compound, ternary compound and/or quaternary compound), may exist (e.g., be included) in a particle at a substantially uniform concentration (e.g., distribution) or at non-uniform concentration.

The quantum dot may have a single structure or a dual core-shell structure. In the case of the quantum dot having a single structure, the concentration (e.g., distribution) of each element included in the corresponding quantum dot may be substantially uniform. In one or more embodiments, the material contained in the core and the material contained in the shell may be different from each other (e.g., the concentration or distribution of elements may vary between the core and the shell).

The shell of the quantum dot may function as a protective layer to prevent or reduce chemical degeneration of the core to maintain semiconductor characteristics, and/or as a charging layer to impart electrophoretic characteristics to the quantum dot. The shell may be a single layer or a multi-layer. The interface between the core and the shell may have a concentration gradient that decreases toward the center of the element present in the shell.

Examples of the shell of the quantum dot may include an oxide of metal, metalloid, or non-metal, a semiconductor compound, and any combination thereof. Examples of the oxide of metal, metalloid, or non-metal are a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, or NiO; a ternary compound, such as MgAl₂O₄, CoFe₂O₄, NiFe₂O₄, or CoMn₂O₄; and any combination thereof. Examples of the semiconductor compound may include, as described herein, Group II-VI semiconductor compounds; Group III-V semiconductor compounds; Group III-VI semiconductor compounds; Group I-III-VI semiconductor compounds; Group IV-VI semiconductor compounds; and combinations thereof. In some embodiments, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

A full width at half maximum (FWHM) of an emission wavelength spectrum of the quantum dot may be about 45 nm or less, for example, about 40 nm or less, for example, about 30 nm or less, and within these ranges, color purity and/or color gamut may be increased. Because the light emitted through the quantum dot is emitted in all directions, the wide viewing angle can be improved.

In some embodiments, the quantum dot may be or include a spherical particle, a pyramidal particle, a multi-arm particle, a cubic nanoparticle, a nanotube particle, a nanowire particle, a nanofiber particle, or a nanoplate particle.

Because the energy band gap can be adjusted or selected by controlling the size of the quantum dot, light having one or more suitable wavelength bands (e.g., emission wavelengths) can be obtained from the quantum dot emission layer. Therefore, by utilizing quantum dots of different sizes, a light-emitting device that emits light of various suitable wavelengths may be implemented. In one or more embodiments, the size of the quantum dot may be selected to emit red, green and/or blue light. In some embodiments, the size of the quantum dot may be configured to emit white light by combining light of various suitable colors.

### Electron transport region 133 in interlayer 130

The electron transport region 133 may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region 133 may include a buffer layer, a hole-blocking layer, an electron control layer, an electron transport layer, an electron injection layer, or any combination thereof.

In an embodiment, the electron transport region 133 may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, wherein, for each structure, constituting layers are sequentially stacked from an emission layer.

In an embodiment, the electron transport region 133 (for example, the buffer layer, the hole-blocking layer, the electron control layer, or the electron transport layer in the electron transport region 133) may include a metal-free compound including at least one π electron-deficient nitrogen-containing C₁-C₆₀ (*e.g.* C₁-C₃₀) cyclic group.

In an embodiment, the electron transport region 133 may include a compound represented by Formula 601:

**Formula 601** [Ar₆₀₁]ₓₑ₁₁-[(L₆₀₁)ₓₑ₁-R₆₀₁]ₓₑ₂₁,

wherein, in Formula 601,
Ar₆₀₁ and L₆₀₁ may each independently be a C₃-C₆₀ (*e.g*. C₃-C₃₀) carbocyclic group unsubstituted or substituted with at least one R₁₀ₐ or a C₁-C₆₀ (*e.g*. C₁-C₂₀) heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (*e.g*. C₃-C₃₀) carbocyclic group unsubstituted or substituted with at least one R₁₀ₐ, a C₁-C₆₀ (*e.g*. C₁-C₂₀) heterocyclic group unsubstituted or substituted with at least one R₁₀ₐ, -Si(Q₆₀₁)(Q₆₀₂)(Q₆₀₃), -C(=O)(Q₆₀₁), - S(=O)₂(Q₆₀₁), or -P(=O)(Q₆₀₁)(Q₆₀₂),
Q₆₀₁ to Q₆₀₃ may each independently be the same as described in connection with Q₁,
xe21 may be 1, 2, 3, 4, or 5,
at least one of Ar₆₀₁, L₆₀₁, and R₆₀₁ may each independently be a π electron-deficient nitrogen-containing C₁-C₆₀ (*e.g*. C₁-C₃₀) cyclic group unsubstituted or substituted with at least one R₁₀ₐ.

For example, when xe11 in Formula 601 is 2 or more, two or more of Ar₆₀₁(s) may be linked via a single bond.

In one or more embodiments, Ar₆₀₁ in Formula 601 may be a substituted or unsubstituted anthracene group.

In an embodiment, the electron transport region 133 may include a compound represented by Formula 601-1:

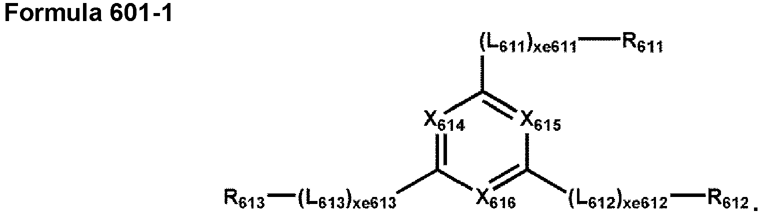

In Formula 601-1,
X₆₁₄ may be N or C(R₆₁₄), X₆₁₅ may be N or C(R₆₁₅), X₆₁₆ may be N or C(R₆₁₆), at least one of X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁,
R₆₁₄ to R₆₁₆ may each independently be hydrogen, deuterium, -F, -Cl, -Br, -I, a hydroxyl group, a cyano group, a nitro group, a C₁-C₂₀ (*e.g*. C₁-C₁₀) alkyl group, a C₁-C₂₀ (*e.g.* C₁-C₁₀) alkoxy group, a C₃-C₆₀ (*e.g*. C₃-C₃₀) carbocyclic group unsubstituted or substituted with at least one R₁₀ₐ, or a C₁-C₆₀ (*e.g*. C₁-C₂₀) heterocyclic group unsubstituted or substituted with at least one R₁₀ₐ.

For example, xe1 and xe611 to xe613 in Formulae 601 and 601-1 may each independently be 0, 1, or 2.

The electron transport region 133 may include one of Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, or any combination thereof:

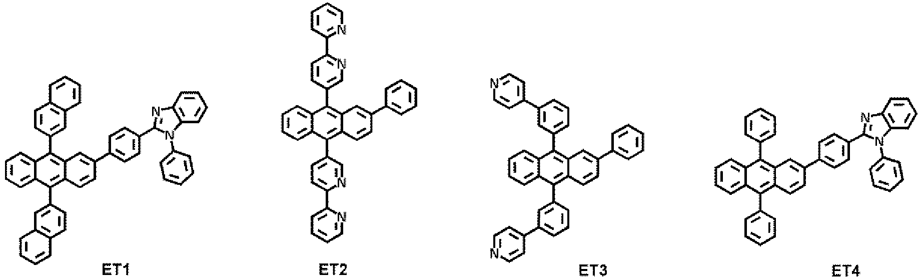

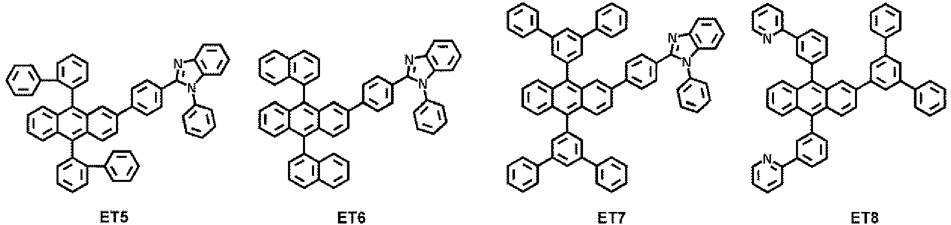

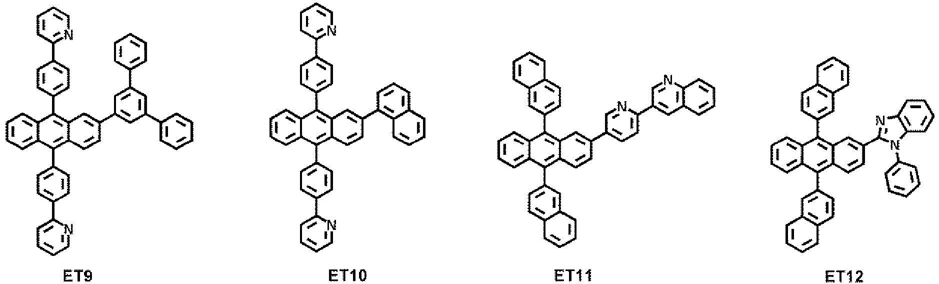

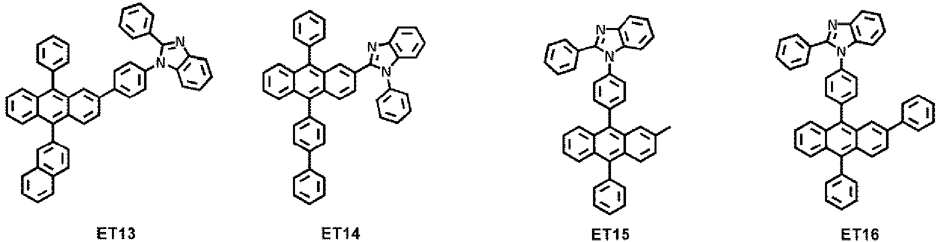

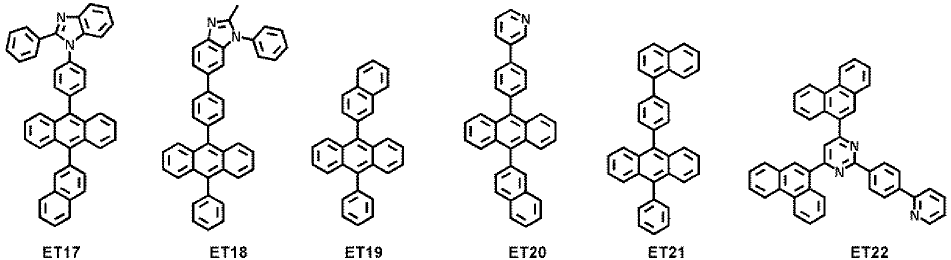

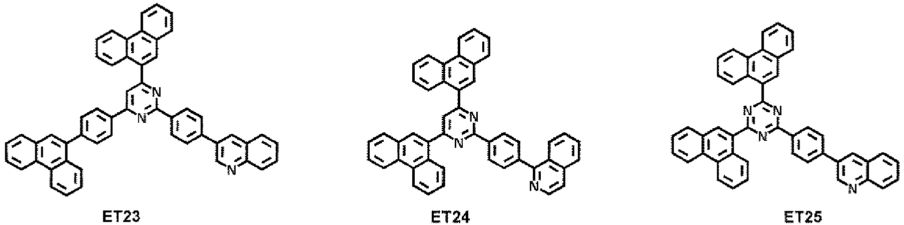

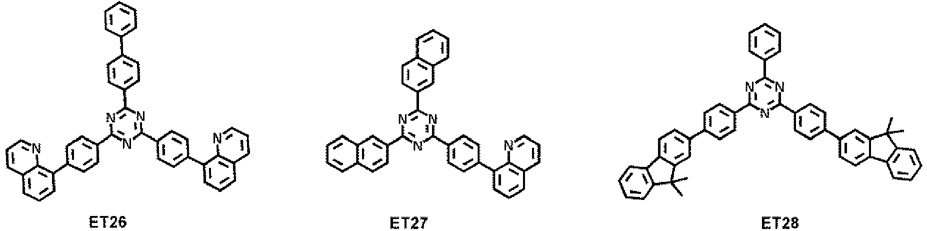

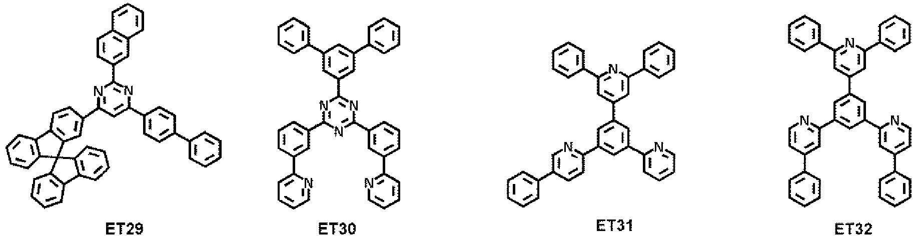

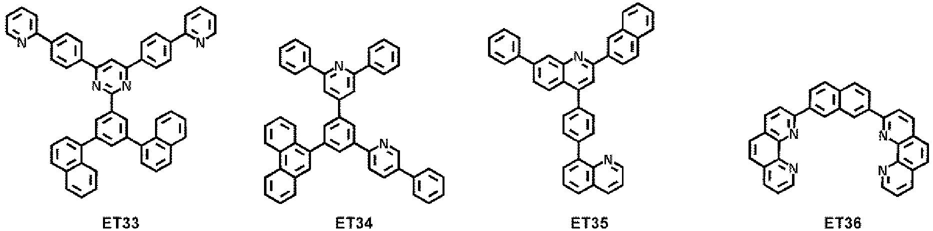

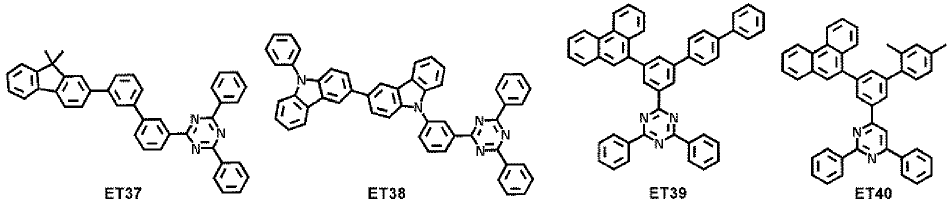

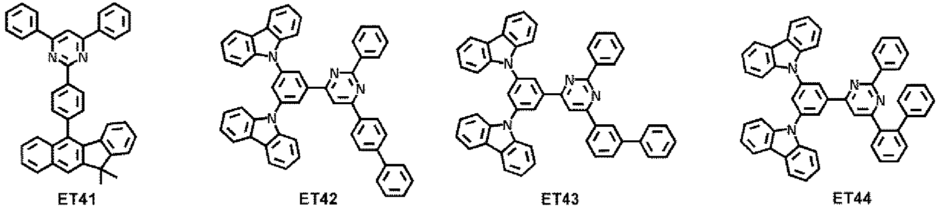

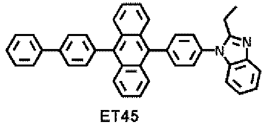

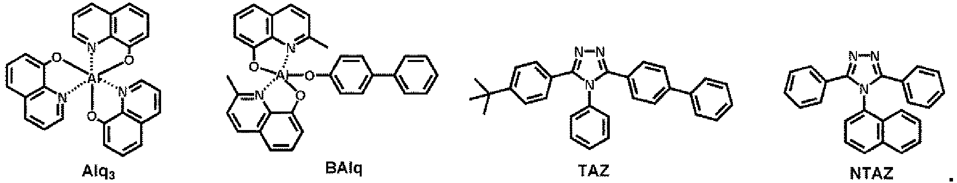

The thickness of the electron transport region 133 may be about 160 Å to about 5,000 Å, for example, about 100 Å to about 4,000 Å. When the electron transport region 133 includes a buffer layer, a hole-blocking layer, an electron control layer, an electron transport layer, or any combination thereof, the thickness of the buffer layer, the hole-blocking layer, and/or the electron control layer may each independently be about 20 Å to about 1000 Å, for example, about 30 Å to about 300 Å, and the thickness of the electron transport layer may be about 100 Å to about 1000 Å, for example, about 150 Å to about 500 Å. When the thicknesses of the buffer layer, hole-blocking layer, electron control layer, electron transport layer and/or electron transport layer are within these ranges, satisfactory electron transporting characteristics may be obtained without a substantial increase in driving voltage.

The electron transport region 133 (for example, the electron transport layer in the electron transport region 133) may further include, in addition to the materials described above, a metal-containing material.

The metal-containing material may include an alkali metal complex, an alkaline earth metal complex, or any combination thereof. The metal ion of the alkali metal complex may be a lithium (Li) ion, a sodium (Na) ion, a potassium (K) ion, a rubidium (Rb) ion, or a cesium (Cs) ion, and the metal ion of the alkaline earth metal complex may be a beryllium (Be) ion, a magnesium (Mg) ion, a calcium (Ca) ion, a strontium (Sr) ion, or a barium (Ba) ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may include a Li complex. The Li complex may include, for example, Compound ET-D1 (LiQ) or ET-D2:

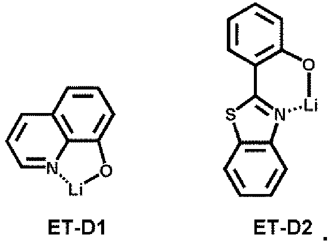

The electron transport region 133 may include an electron injection layer to facilitate injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may each independently be or include oxides, halides (for example, fluorides, chlorides, bromides, and/or iodides), and/or tellurides of the alkali metal, the alkaline earth metal, the rare earth metal, or combinations thereof.

The alkali metal-containing compound may include alkali metal oxides (such as Li₂O, Cs₂O, and/or K₂O), alkali metal halides (such as LiF, NaF, CsF, KF, Lil, Nal, CsI, and/or KI), or any combination thereof. The alkaline earth metal-containing compound may include an alkaline earth metal compound (such as BaO, SrO, CaO, BaₓSr₁₋ₓO (x is a real number satisfying the condition of 0<x<1), BaₓCa₁₋ₓO (x is a real number satisfying the condition of 0<x<1), and/or the like). The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and/or Lu₂Te₃.

The alkali metal complex, the alkaline earth-metal complex, and the rare earth metal complex may respectively include i) an alkali metal ion, an alkaline earth metal ion, and a rare earth metal ion, and ii) a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, a compound represented by Formula 601).

In one or more embodiments, the electron injection layer may include (e.g., consist of) i) an alkali metal-containing compound (for example, an alkali metal halide), ii) a) an alkali metal-containing compound (for example, an alkali metal halide); and b) an alkali metal, an alkaline earth metal, a rare earth metal, or any combination thereof. In one or more embodiments, the electron injection layer may be a KI:Yb co-deposited layer, an Rbl:Yb co-deposited layer, and/or the like.

When the electron injection layer further includes an organic material, the alkali metal, alkaline earth metal, rare earth metal, alkali metal-containing compound, alkaline earth metal-containing compound, rare earth metal-containing compound, alkali metal complex, alkaline earth-metal complex, rare earth metal complex, or combination thereof may be homogeneously or non-homogeneously dispersed in a matrix including the organic material.

A thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

### Second electrode 150

The second electrode 150 may be located on the interlayer 130 having such a structure. The second electrode 150 may be a cathode, which is an electron injection electrode, and as the material for the second electrode 150, a metal, an alloy, an electrically conductive compound, or any combination thereof, each having a low work function, may be utilized.

In one or more embodiments, the second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layered structure or a multi-layered structure including two or more layers.

### Capping layer

A first capping layer may be located outside (e.g., on the outer side of) the first electrode 110, and/or a second capping layer may be located outside (e.g., on the outer side of) the second electrode 150. In detail, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

Light generated in an emission layer of the interlayer 130 of the light-emitting device 10 may be extracted toward the outside through the first electrode 110, which is a semi-transmissive electrode or a transmissive electrode, and the first capping layer or light generated in an emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase the external emission efficiency of a device according to the principle of constructive interference. Accordingly, the light extraction efficiency of the light-emitting device 10 is increased, so that the emission efficiency of the light-emitting device 10 may be improved.

Each of the first capping layer and second capping layer may include a material having a refractive index (at about 589 nm) of about 1.6 or more.

The first capping layer and the second capping layer may each independently be an organic capping layer including an organic material, an inorganic capping layer including an inorganic material, or a composite capping layer including an organic material and an inorganic material.

At least one selected from the first capping layer and the second capping layer may each independently include a carbocyclic compound, a heterocyclic compound, an amine group-containing compound, a porphyrin derivative, a phthalocyanine derivative, a naphthalocyanine derivative, an alkali metal complex, an alkaline earth metal complex, or any combination thereof. The carbocyclic compound, the heterocyclic compound, and the amine group-containing compound may be optionally substituted with a substituent containing oxygen (O), nitrogen (N), sulfur (S), selenium (Se), silicon (Si), fluorine (F), chlorine (Cl), bromine (Br), iodine (I), or any combination thereof. In one or more embodiments, at least one of the first capping layer and the second capping layer may each independently include an amine group-containing compound.

In one or more embodiments, at least one of the first capping layer and the second capping layer may each independently include a compound represented by Formula 201, a compound represented by Formula 202, or any combination thereof.

In one or more embodiments, at least one of the first capping layer and the second capping layer may each independently include one of Compounds HT28 to HT33, one of Compounds CP1 to CP6, β-NPB, or any combination thereof:

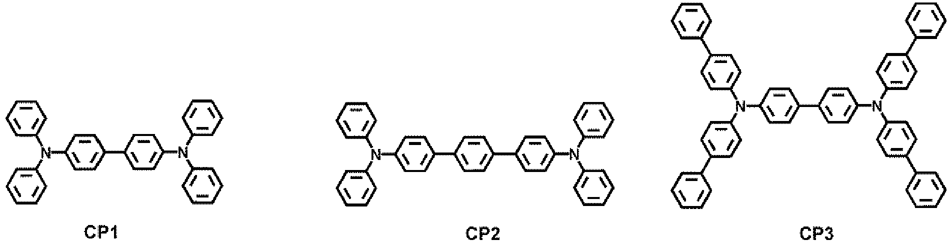

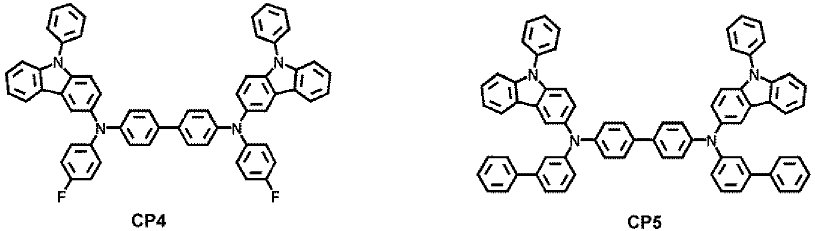

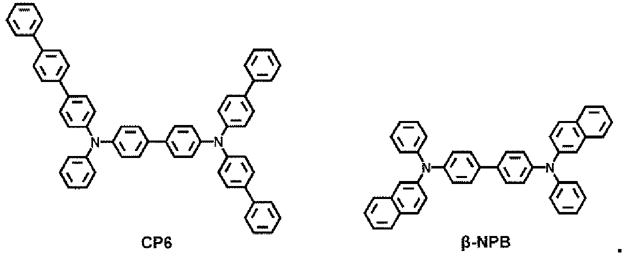

### Electronic apparatus

The light-emitting device may be included in various suitable electronic apparatuses. In one or more embodiments, the electronic apparatus including the light-emitting device may be a light-emitting apparatus, an authentication apparatus, and/or the like.

The electronic apparatus (for example, light-emitting apparatus) may further include, in addition to the light-emitting device, i) a color filter, ii) a color conversion layer, or iii) a color filter and a color conversion layer. The color filter and/or the color conversion layer may be located in at least one traveling direction of light emitted from the light-emitting device. In one or more embodiments, the light emitted by the light-emitting device may be blue light or white light. The light-emitting device may be the same as described above. In one or more embodiments, the color conversion layer may include quantum dots. The quantum dot may be, for example, the same as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be located among the subpixel areas to define each of the subpixel areas.

The color filter may further include a plurality of color filter areas and light-shielding patterns located among the color filter areas, and the color conversion layer may include a plurality of color conversion areas and light-shielding patterns located among the color conversion areas.

The color filter areas (or the color conversion areas) may include a first area to emit first color light, a second area to emit second color light, and/or a third area to emit third color light, and the first color light, the second color light, and/or the third color light may have different maximum emission wavelengths from one another. In one or more embodiments, the first color light may be red light, the second color light may be green light, and the third color light may be blue light. In one or more embodiments, the color filter areas (or the color conversion areas) may include quantum dots. For example, the first area may include a red quantum dot, the second area may include a green quantum dot, and the third area may not include a quantum dot. The quantum dot may be the same as described in the present specification. The first area, the second area, and/or the third area may each include a scatterer (e.g., scattering material or agent).

In one or more embodiments, the light-emitting device may be to emit first light, the first area may be to absorb the first light to emit first first-color light, the second area may be to absorb the first light to emit second first-color light, and the third area may be to absorb the first light to emit third first-color light. In this regard, the first first-color light, the second first-color light, and the third first-color light may have different maximum emission wavelengths. For example, the first light may be blue light, the first first-color light may be red light, the second first-color light may be green light, and the third first-color light may be blue light.

The electronic apparatus may further include a thin-film transistor in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, etc.

The activation layer may include crystalline silicon, amorphous silicon, organic semiconductor, oxide semiconductor, and/or the like.

The electronic apparatus may further include a sealing portion for sealing the light-emitting device. The sealing portion and/or the color conversion layer may be placed between the color filter and the light-emitting device. The sealing portion allows light from the light-emitting device to be extracted to the outside, while concurrently (e.g., simultaneously) preventing or reducing ambient air and/or moisture from penetrating into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally located on the sealing portion, in addition to the color filter and/or the color conversion layer, according to the intended use of the electronic apparatus. The functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device, a biometric information collector.

The electronic apparatus may be applied to various suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various measuring instruments, meters (for example, meters for a vehicle, an aircraft, and a vessel), projectors, and/or the like.

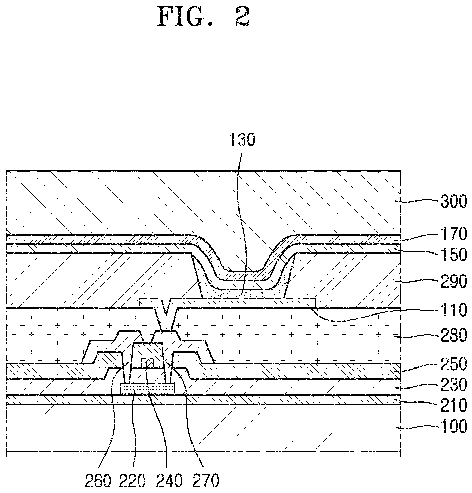

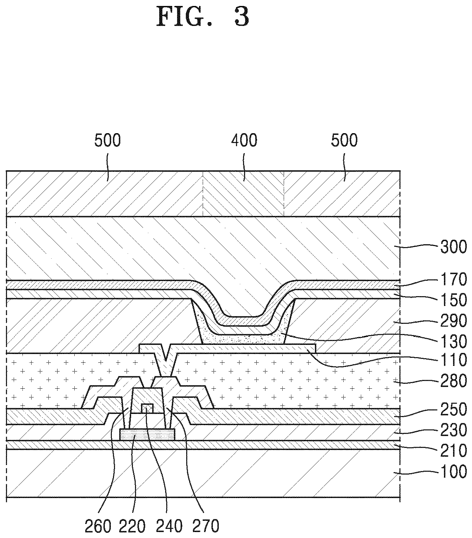

### Description of FIGS. 2 and 3

FIG. 2 is a cross-sectional view showing a light-emitting apparatus according to an embodiment of the present disclosure.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be formed on the substrate 100. The buffer layer 210 may prevent or reduce penetration of impurities through the substrate 100 and may provide a flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor (such as silicon and/or polysilicon), an organic semiconductor, and/or an oxide semiconductor, and may include a source region, a drain region and a channel region.

A gate insulating film 230 for insulating the activation layer 220 from the gate electrode 240 may be located on the activation layer 220, and the gate electrode 240 may be located on the gate insulating film 230.

An interlayer insulating film 250 is located on the gate electrode 240. The interlayer insulating film 250 may be placed between the gate electrode 240 and the source electrode 260 to insulate the gate electrode 240 from the source electrode 260, and/or between the gate electrode 240 and the drain electrode 270 to insulate the gate electrode 240 from the drain electrode 270.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be in contact with the exposed portions of the source region and the drain region of the activation layer 220.

The TFT is electrically connected to a light-emitting device to drive the light-emitting device, and may be covered by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be formed on the passivation layer 280. The passivation layer 280 does not completely cover the drain electrode 270 and exposes a portion of the drain electrode 270, and the first electrode 110 is connected to the exposed portion of the drain electrode 270.

A pixel defining layer 290 containing an insulating material may be located on the first electrode 110. The pixel defining layer 290 exposes a region of the first electrode 110, and an interlayer 130 may be formed in the exposed region of the first electrode 110. The pixel defining layer 290 may be a polyimide or polyacrylic organic film. In some embodiments, at least some layers of the interlayer 130 may extend beyond the upper portion of the pixel defining layer 290 to be located in the form of a common layer.

The second electrode 150 may be located on the interlayer 130, and a capping layer 170 may be additionally formed on the second electrode 150. The capping layer 170 may be formed to cover the second electrode 150.

The encapsulation portion 300 may be located on the capping layer 170. The encapsulation portion 300 may be located on a light-emitting device to protect the light-emitting device from moisture and/or oxygen. The encapsulation portion 300 may include: an inorganic film including silicon nitride (SiNₓ), silicon oxide (SiOₓ), indium tin oxide, indium zinc oxide, or any combination thereof, an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or a combination thereof, for example, a combination of the inorganic film and the organic film.

FIG. 3 shows a cross-sectional view showing a light-emitting apparatus according to an embodiment of the present disclosure.

The light-emitting apparatus of FIG. 3 is the same as the light-emitting apparatus of FIG. 2, except that a light-shielding pattern 500 and a functional region 400 are additionally located on the encapsulation portion 300. The functional region 400 may be a combination of i) a color filter area, ii) a color conversion area, or iii) a combination of the color filter area and the color conversion area. In one or more embodiments, the light-emitting device included in the light-emitting apparatus of FIG. 3 may be a tandem light-emitting device.

### Manufacture method

Respective layers included in the hole transport region, the emission layer 132, and respective layers included in the electron transport region 133 may be formed in a set or predetermined region by utilizing one or more suitable methods selected from vacuum deposition, spin coating, casting, Langmuir-Blodgett (LB) deposition, inkjet printing, laser-printing, and laser-induced thermal imaging.

When the layers constituting the hole transport region, the emission layer 132, and the layers constituting the electron transport region 133 are formed by vacuum deposition, the deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of Terms

The term "C₃-C₆₀ carbocyclic group" as used herein refers to a cyclic group consisting of carbon only as a ring-forming atom and having three to sixty carbon atoms, and the term "C₁-C₆₀ heterocyclic group" as used herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed with each other. For example, the C₁-C₆₀ heterocyclic group has 3 to 61 ring-forming atoms.

The term "cyclic group" as used herein may include the C₃-C₆₀ carbocyclic group and the C₁-C₆₀ heterocyclic group.

The term "π electron-rich C₃-C₆₀ cyclic group" as used herein refers to a cyclic group that has three to sixty carbon atoms and does not include *-N=*' as a ring-forming moiety, and the term "π electron-deficient nitrogen-containing C₁-C₆₀ cyclic group" as used herein refers to a heterocyclic group that has one to sixty carbon atoms and includes *-N=*' as a ring-forming moiety.

For example,
the C₃-C₆₀ carbocyclic group may be i) a group T1 (defined below) or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a group T2 (defined below), ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) group T1, ii) a condensed cyclic group in which two or more groups T1 are condensed with each other, iii) a group T3 (defined below), iv) a condensed cyclic group in which two or more groups T3 are condensed with each other, or v) a condensed cyclic group in which at least one group T3 and at least one group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) a group T4 (defined below), ii) a condensed cyclic group in which two or more groups T4 are condensed with each other, iii) a condensed cyclic group in which at least one group T4 and at least one group T1 are condensed with each other, iv) a condensed cyclic group in which at least one group T4 and at least one group T3 are condensed with each other, or v) a condensed cyclic group in which at least one group T4, at least one group T1, and at least one group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
where group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
group T3 may be a furan group, a thiophene group, a 1H-pyrrole group, a silole group, or a borole group, and
group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "cyclic group", "C₃-C₆₀ carbocyclic group", "C₁-C₆₀ heterocyclic group", "π electron-rich C₃-C₆₀ cyclic group", and/or "π electron-deficient nitrogen-containing C₁-C₆₀ cyclic group" as used herein refer to a group condensed to any cyclic group or a polyvalent group (for example, a divalent group, a trivalent group, a tetravalent group, etc.), depending on the structure of a formula in connection with which the terms are used. In one or more embodiments, "a benzene group" may be a benzo group, a phenyl group, a phenylene group, and/or the like, which may be easily understood by one of ordinary skill in the art according to the context and structure of a formula including the "benzene group."

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and examples of the divalent C₃-C₆₀ carbocyclic group and the monovalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and/or a substituted or unsubstituted divalent non-aromatic condensed heteropolycyclic group.

The term "C₁-C₆₀ alkyl group" as utilized herein refers to a linear or branched aliphatic hydrocarbon monovalent group that has one to sixty carbon atoms, and examples thereof may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and/or a tert-decyl group. The term "C₁-C₆₀ alkylene group" as utilized herein refers to a divalent group having substantially the same structure as the C₁-C₆₀ alkyl group. Corresponding definitions apply to other ranges given for the number of carbon atoms in an alkyl/alkylene group.

The term "C₂-C₆₀ alkenyl group" as utilized herein refers to a monovalent hydrocarbon group having at least one carbon-carbon double bond in the middle or at the terminus of the C₂-C₆₀ alkyl group, and examples thereof may include an ethenyl group, a propenyl group, and/or a butenyl group. The term "C₂-C₆₀ alkenylene group" as utilized herein refers to a divalent group having substantially the same structure as the C₂-C₆₀ alkenyl group. Corresponding definitions apply to other ranges given for the number of carbon atoms in an alkenyl/alkenylene group.

The term "C₂-C₆₀ alkynyl group" as utilized herein refers to a monovalent hydrocarbon group having at least one carbon-carbon triple bond in the middle or at the terminus of the C₂-C₆₀ alkyl group, and examples thereof may include an ethynyl group and/or a propynyl group. The term "C₂-C₆₀ alkynylene group" as utilized herein refers to a divalent group having substantially the same structure as the C₂-C₆₀ alkynyl group. Corresponding definitions apply to other ranges given for the number of carbon atoms in an alkynyl/alkynylene group.

The term "C₁-C₆₀ alkoxy group" as utilized herein refers to a monovalent group represented by -OA₁₀₁ (wherein A₁₀₁ is a C₁-C₆₀ alkyl group), and examples thereof may include a methoxy group, an ethoxy group, and/or an isopropyloxy group. Corresponding definitions apply to other ranges given for the number of carbon atoms in an alkoxy group.

The term "C₃-C₁₀ cycloalkyl group" as utilized herein refers to a monovalent saturated hydrocarbon cyclic group having 3 to 10 carbon atoms, and examples thereof may include a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and/or a bicyclo[2.2.2]octyl group. The term "C₃-C₁₀ cycloalkylene group" as utilized herein refers to a divalent group having substantially the same structure as the C₃-C₁₀ cycloalkyl group.

The term "C₁-C₁₀ heterocycloalkyl group" as utilized herein refers to a monovalent cyclic group that further includes, in addition to 1 to 10 carbon atoms, at least one heteroatom as a ring-forming atom, and examples thereof may include a 1,2,3,4-oxatriazolidinyl group, a tetrahydrofuranyl group, and/or a tetrahydrothiophenyl group. The term "C₁-C₁₀ heterocycloalkylene group" as utilized herein refers to a divalent group having substantially the same structure as the C₁-C₁₀ heterocycloalkyl group.

The term C₃-C₁₀ cycloalkenyl group utilized herein refers to a monovalent cyclic group that has three to ten carbon atoms, at least one carbon-carbon double bond in the ring thereof, and no aromaticity (e.g., the group is non-aromatic), and examples thereof may include a cyclopentenyl group, a cyclohexenyl group, and/or a cycloheptenyl group. The term "C₃-C₁₀ cycloalkenylene group" as utilized herein refers to a divalent group having substantially the same structure as the C₃-C₁₀ cycloalkenyl group.

The term "C₁-C₁₀ heterocycloalkenyl group" as utilized herein refers to a monovalent cyclic group that has, in addition to 1 to 10 carbon atoms, at least one heteroatom as a ring-forming atom, and at least one carbon-carbon double bond in the cyclic structure thereof. Examples of the C₁-C₁₀ heterocycloalkenyl group may include a 4,5-dihydro-1,2,3,4-oxatriazolyl group, a 2,3-dihydrofuranyl group, and/or a 2,3-dihydrothiophenyl group. The term "C₁-C₁₀ heterocycloalkenylene group" as utilized herein refers to a divalent group having substantially the same structure as the C₁-C₁₀ heterocycloalkenyl group.

The term "C₆-C₆₀ aryl group" as utilized herein refers to a monovalent group having a carbocyclic aromatic system having six to sixty carbon atoms, and the term "C₆-C₆₀ arylene group" as utilized herein refers to a divalent group having a carbocyclic aromatic system having six to sixty carbon atoms. Examples of the C₆-C₆₀ aryl group may include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and/or an ovalenyl group. When the C₆-C₆₀ aryl group and the C₆-C₆₀ arylene group each include two or more rings, the rings may be condensed with each other. Corresponding definitions apply to other ranges given for the number of carbon atoms in an aryl/arylene group.

The term "C₁-C₆₀ heteroaryl group" as utilized herein refers to a monovalent group having a heterocyclic aromatic system that has, in addition to a carbon atom, at least one heteroatom as a ring-forming atom, and 1 to 60 carbon atoms. The term "C₁-C₆₀ heteroarylene group" as utilized herein refers to a divalent group having a heterocyclic aromatic system that has, in addition to a carbon atom, at least one heteroatom as a ring-forming atom, and 1 to 60 carbon atoms. Examples of the C₁-C₆₀ heteroaryl group may include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed with each other. Corresponding definitions apply to other ranges given for the number of carbon atoms in an heteroaryl/heteroarylene group.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure (e.g., no aromatic conjugation system extends across the entire structure, although portions of the group may contain conjugated systems). Examples of the monovalent non-aromatic condensed polycyclic group may include an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as utilized herein refers to a divalent group having substantially the same structure as a monovalent non-aromatic condensed polycyclic group.

The term "monovalent non-aromatic condensed heteropolycyclic group" as utilized herein refers to a monovalent group (for example, having 1 to 60 carbon atoms) having two or more rings condensed to each other, at least one heteroatom other than carbon atoms, as a ring-forming atom, and non-aromaticity in its entire molecular structure (e.g., no aromatic conjugation system extends across the entire structure, although portions of the group may contain conjugated systems). Examples of the monovalent non-aromatic condensed heteropolycyclic group may include an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic heterocondensed polycyclic group" as utilized herein refers to a divalent group having substantially the same structure as a monovalent non-aromatic heterocondensed polycyclic group.

The term "C₆-C₆₀ aryloxy group" as utilized herein indicates -OA₁₀₂ (wherein A₁₀₂ is a C₆-C₆₀ aryl group), and the term "C₆-C₆₀ arylthio group" as utilized herein indicates -SA₁₀₃ (wherein A₁₀₃ is a C₆-C₆₀ aryl group). Corresponding definitions apply to other ranges given for the number of carbon atoms in an aryloxy group and an arylthio group.

The term "C₇-C₆₀ aryl alkyl group" utilized herein refers to -A₁₀₄A₁₀₅ (where A₁₀₄ may be a C₁-C₅₄ alkylene group, and A₁₀₅ may be a C₆-C₅₉ aryl group), and the term C₂-C₆₀ heteroaryl alkyl group" utilized herein refers to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as utilized herein refers to:
deuterium (-D), -F, -Cl, -Br, -I, a hydroxyl group, a cyano group, or a nitro group;
a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, or a C₁-C₆₀ (e.g. C₁-C₂₀) alkoxy group, each unsubstituted or substituted with deuterium, -F, -Cl, -Br, -I, a hydroxyl group, a cyano group, a nitro group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof,
a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) aryl alkyl group, or a C₂-C₆₀ (e.g. C₂-C₂₀) heteroaryl alkyl group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (e.g. C₁-C₂₀) alkoxy group, a C₃-C₆₀ (e.g. C₃-C₃₀) carbocyclic group, a C₁-C₆₀ (e.g. C₁-C₂₀) heterocyclic group, a C₆-C₆₀ (e.g. C₆-C₃₀) aryloxy group, a C₆-C₆₀ (e.g. C₆-C₃₀) arylthio group, a C₇-C₆₀ (e.g. C₇-C₃₀) aryl alkyl group, a C₂-C₆₀ (e.g. C₂-C₂₀) heteroaryl alkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃ and Q₃₁ to Q₃₃ utilized herein may each independently be: hydrogen; deuterium; -F; -Cl; -Br; -I; a hydroxyl group; a cyano group; a nitro group; a C₁-C₆₀ (e.g. C₁-C₂₀) alkyl group; a C₂-C₆₀ (e.g. C₂-C₂₀) alkenyl group; a C₂-C₆₀ (e.g. C₂-C₂₀) alkynyl group; a C₁-C₆₀ (e.g. C₁-C₂₀) alkoxy group; a C₃-C₆₀ (e.g. C₃-C₃₀) carbocyclic group or a C₁-C₆₀ (e.g. C₁-C₂₀) heterocyclic group, each unsubstituted or substituted with deuterium, -F, a cyano group, a C₁-C₆₀ (e.g. C₁-C₂₀) alkyl group, a C₁-C₆₀ (e.g. C₁-C₂₀) alkoxy group, a phenyl group, a biphenyl group, or any combination thereof; a C₇-C₆₀ (e.g. C₇-C₃₀) aryl alkyl group; or a C₂-C₆₀ (e.g. C₂-C₂₀) heteroaryl alkyl group.

The term "heteroatom" as utilized herein refers to any atom other than a carbon atom and a hydrogen atom. Examples of the heteroatom may include O, S, N, P, Si, B, Ge, Se, and any combination thereof.

The term "third-row transition metal" utilized herein includes hafnium (Hf), tantalum (Ta), tungsten(W), rhenium (Re), osmium (Os), iridium (Ir), platinum (Pt), gold (Au), etc.

The term "Ph" as utilized herein refers to a phenyl group, the term "Me" as utilized herein refers to a methyl group, the term "Et" as utilized herein refers to an ethyl group, the term "ter-Bu" or "Bu^{t}" as utilized herein refers to a tert-butyl group, and the term "OMe" as utilized herein refers to a methoxy group.

The term "biphenyl group" as utilized herein refers to "a phenyl group substituted with a phenyl group." In other words, the "biphenyl group" is a substituted phenyl group having a C₆-C₆₀ aryl group as a substituent.

The term "terphenyl group" as utilized herein refers to "a phenyl group substituted with a biphenyl group". In other words, the "terphenyl group" is a substituted phenyl group having, as a substituent, a C₆-C₆₀ aryl group substituted with a C₆-C₆₀ aryl group.

* and *' as utilized herein, unless defined otherwise, each refer to a binding site to a neighboring atom in a corresponding formula or moiety.

Hereinafter, a light-emitting device according to embodiments will be described in more detail with reference to Examples.

### Example

### Example 1

In₂O₃ and SnO₂ were vacuum-deposited at a weight ratio of 95:5 on a glass substrate on which ITO and Ag are stacked in order to form an anode having a thickness of 600 Å, and HT3 was vacuum-deposited on the anode to form a hole transport layer having a thickness of 300 Å.

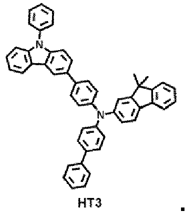

ADN and DPAVBi (the amount of DPAVBi was 5 wt%) were co-deposited on the hole transport layer to form an emission layer having a thickness of 300 Å.

ET1 was deposited on the emission layer to form an electron transport layer having a thickness of 300 Å, and then Yb was deposited on the electron transport layer to form an electron injection layer having a thickness of 13 Å, and AgMg was co-deposited at a weight ratio of 10:1 on the electron injection layer to form a cathode having a thickness of 100 Å, thereby completing the manufacture of a light-emitting device.

Work function of anode (weight ratio of 95:5 for In₂O₃ and SnO₂): -5.20 eV
E_{HOMO_HTL}: -5.15 eV

### Comparative Example 1

As a substrate and an anode, a glass substrate with 15 Ωcm² (1,200 Å) ITO thereon, which was manufactured by Corning Inc., was cut to a size of 50 mm×50 mm×0.7 mm, and the glass substrate was sonicated by utilizing isopropyl alcohol and pure water for 5 minutes each, and then ultraviolet (UV) light was irradiated for 30 minutes thereto and ozone was exposed thereto for cleaning. Then, the resultant glass substrate was loaded onto a vacuum deposition apparatus.

HT3 and HAT-CN were deposited at a ratio of 9:1 on the ITO anode formed on the glass substrate, to form a hole injection layer having a thickness of 100 Å.

HT3 was vacuum-deposited on the hole injection layer to form a hole transport layer having a thickness of a 300 Å.

ADN and DPAVBi (the amount of DPAVBi was 5 wt%) were co-deposited on the hole transport layer to form an emission layer having a thickness of 300 Å.

ET1 was deposited on the emission layer to form an electron transport layer having a thickness of 300 Å, and then Yb was deposited on the electron transport layer to form an electron injection layer having a thickness of 13 Å, and AgMg was co-deposited at a weight ratio of 10:1 on the electron injection layer to form a cathode having a thickness of 100 Å, thereby completing the manufacture of a light-emitting device.

### Comparative Example 2

A light-emitting device was manufactured in substantially the same manner as in Example 1, except that In₂O₃ and SnO₂ were vacuum-deposited at a weight ratio of 90:10 to form an anode having a thickness of 600 Å.

Work function of anode (weight ratio of 90:10 for In₂O₃ and SnO₂): -5.00 eV
E_{HOMO_HTL}: -5.15 eV

### Comparative Example 3

A light-emitting device was manufactured in substantially the same manner as in Example 1, except that GZO (the weight ratio of ZnO and Ga was 95:5) was vacuum-deposited at a weight ratio of 90:10 to form an anode having a thickness of 600 Å.

Work function of anode (GZO):-4.5 eV
E_{HOMO_HTL}: -5.15 eV

### Comparative Example 4

A light-emitting device was manufactured in substantially the same manner as in Example 1, except that HT3 and HAT-CN were deposited at a ratio of 9:1 on the anode to form a hole injection layer having a thickness of 100 Å, and HT3 was vacuum-deposited on the hole injection layer to form a hole transport layer having a thickness of 300 Å.

### Evaluation Example 1

The driving voltage, efficiency and lifespan of the light-emitting devices manufactured according to Example 1 and Comparative Examples 1 to 4 were measured utilizing a color luminance meter, a Keithley source meter device, and a current fixed room temperature lifespan device. Results thereof are shown in Table 1.

**Table 1**

| | Driving voltage (eV) | Blue efficiency (cd/A/y) | Lifespan (T₉₅, hr) |
|---|---|---|---|
| Example 1 | 3.9 | 132 | 400 |
| Comparative Example 1 | 3.9 | 130 | 405 |
| Comparative Example 2 | 4.6 | 123 | 68 |
| Comparative Example 3 | 4.7 | 110 | 37 |
| Comparative Example 4 | 3.9 | 133 | 390 |

Referring to Table 1, it was confirmed that the light-emitting device of Example 1 has a lower driving voltage, higher luminescence efficiency, and a longer lifespan (simultaneously) than the light-emitting devices of Comparative Examples 1 to 4, in which at least one of the three characteristics is relatively degraded.

### Evaluation Example 2

The conductivity of each of the light-emitting devices manufactured according to Example 1 and Comparative Example 4 was measured by utilizing a transmission-line matrix method (TLM). Results thereof are shown in Table 2.

**Table 2**

| | Conductivity |
|---|---|
| Example 1 | 1.0*E-04 (S/m) |
| Comparative Example 4 | 1.0 *E-03 (S/m) |

Referring to Table 2, it can be seen that the conductivity of Comparative Example 4 was higher than that of Example 1 due to the inclusion of the hole injection layer containing a p-dopant.

When the conductivity of the hole transport layer is high, leakage current may occur in the lateral direction.

In the light-emitting device, a p-doping layer is omitted to simplify the process so that production costs are reduced, and compared to a light-emitting device of the related art, substantially the same level of driving voltage, efficiency and/or lifespan may be obtained, color mixing due to leakage current may not occur (e.g., may be reduced), and/or color purity and/or color accuracy may be improved.

According to the present disclosure, the work function of an upper layer from among layers constituting an anode is adjusted, so that without a hole injection layer, smooth hole injection characteristics may be obtained.

As used herein, the terms "substantially," "about," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

It should be understood that the embodiments described herein should be considered in a descriptive sense only and not for purposes of limitation. Descriptions of features or aspects within each embodiment should typically be considered as being available for other similar features or aspects in other embodiments. While one or more embodiments have been described with reference to the drawings, it will be understood by those of ordinary skill in the art that various changes in form and details may be made therein without departing from the scope as defined by the following claims.

## Claims

1. A light-emitting device (10) comprising:
a first electrode (110);
a second electrode (150) facing the first electrode (110), and
an interlayer (130) comprising:
an emission layer (132) between the first electrode (110) and the second electrode (150),
a hole transport layer (131) between the first electrode (110) and the emission layer (132), and
an electron transport region (133) between the emission layer (132) and the second electrode (150), wherein:
the first electrode (110) and the hole transport layer (131) are in direct contact,
the first electrode (110) has a multi-layered structure, in which a first layer (110-1) to an m^{th} layer (110-m)**,** m is an integer of 3 or more, are sequentially stacked,
the m^{th} layer (110-m) consists of a first inorganic material, which is:
a single material selected from GeO₂, and WOₓ (2.1≤x≤2.99); or
a mixed material of any combination of two or more selected from the group consisting of In₂O₃, GeO₂, SnO₂, MoO₃, and WOₓ,
an absolute value of a work function of the first inorganic material is greater than or equal to an absolute value of a highest occupied molecular orbital (HOMO) energy level of the hole transport layer (131),
the absolute value of a HOMO energy level of the hole transport layer (131) is 5.15 eV or less,
the hole transport layer (131) does not comprise a p-dopant,
wherein the m^{th} layer is a layer closest to the second electrode from among the first to m^{th} layers sequentially stacked,
wherein the HOMO energy level of the hole transport layer is determined using cyclic voltammetry as detailed in the description, and
wherein the work function of the first inorganic material is determined by ultraviolet photoelectron spectroscopy as detailed in the description.

2. The light-emitting device (10) of claim 1, wherein:
i) m is 3, the first layer (110-1) comprises ITO, the second layer comprises Ag, and the third layer consists of the first inorganic material,
ii) m is 3, the first layer (110-1) and the third layer each consist of the first inorganic material, and the second layer comprises Ag, or
iii) m is 4, the first (110-1) and third layers each comprise ITO, the second layer comprises Ag, and the fourth layer consists of the first inorganic material.

3. The light-emitting device (10) of claim 1 or claim 2, wherein:
the absolute value of the work function of the first inorganic material is 5.20 eV or more.

4. The light-emitting device (10) of any one of claims 1 to 3, wherein the first inorganic material is:
WOₓ;
a mixed material consisting of In₂O₃, GeO₂ and SnO₂; or
a mixed material in which In₂O₃ is doped with a concentration of 5 wt% or less in at least one selected from SnO₂, MoO₃, and WOₓ.

5. The light-emitting device (10) of any one of claims 1 to 4, wherein the m^{th} layer (110-m) and the hole transport layer (131) make an ohmic contact.

6. The light-emitting device (10) of any one of claims 1 to 5, further comprising an electron-blocking layer between the hole transport layer (131) and the emission layer (132), optionally wherein:
an absolute value of a HOMO energy level of the electron-blocking layer is equal to or greater than an absolute value of a HOMO energy level of the emission layer (132), and is equal to or less than an absolute value of a HOMO energy level of the hole transport layer (131).

7. The light-emitting device (10) of any one of claims 1 to 6, wherein the electron transport region (133) comprises a buffer layer (210), a hole-blocking layer, an electron control layer, an electron transport layer, an electron injection layer, or any combination thereof.

8. The light-emitting device (10) of claim 7, wherein the electron transport region (133) comprises a hole-blocking layer, an electron transport layer, and an electron injection layer, which are sequentially arranged between the emission layer (132) and the second electrode (150), optionally wherein:
an absolute value of a HOMO energy level of the hole-blocking layer is equal to or less than an absolute value of a HOMO energy level of the emission layer (132), and is equal to or less than an absolute value of a HOMO energy level of the electron transport layer.

9. The light-emitting device (10) of any one of claims 1 to 8, wherein:
(i) the emission layer (132) comprises a host and a dopant, and the dopant comprises a phosphorescent dopant, a fluorescent dopant, or any combination thereof,
the emission layer (132) comprises quantum dots, or
the emission layer (132) comprises a delayed fluorescence material, and the delayed fluorescence material functions as a host or a dopant in the emission layer (132); and/or
(ii) the first electrode (110) is an anode, and
the second electrode (150) is a cathode.

10. The light-emitting device (10) of any one of claims 1 to 9, wherein:
(i) the light-emitting device (10) further comprises at least one of a first capping layer outside the first electrode (110) and a second capping layer outside the second electrode (150),
wherein each of the first capping layer and the second capping layer comprises a material having a refractive index of 1.6 or more at a wavelength of 589 nm; and/or
(ii) the interlayer (130) comprises:
two or more light-emitting units sequentially stacked between the first electrode (110) and the second electrode (150); and
one or more charge generation layers between any neighboring two light-emitting units among the two or more light-emitting units.

11. An electronic apparatus comprising the light-emitting device (10) of any one of claims 1 to 10.

12. The electronic apparatus of claim 11, further comprising:
(i) a thin-film transistor (TFT),
wherein the thin-film transistor (TFT) comprises a source electrode (260) and a drain electrode (270), and
the first electrode (110) of the light-emitting device (10) is electrically connected to at least one of the source electrode (260) and the drain electrode (270) of the thin-film transistor (TFT); and/or
(ii) a color filter, a color conversion layer, a touch screen layer, a polarizing layer, or any combination thereof.

## Patentansprüche

1. Lichtemittierende Vorrichtung (10), die Folgendes umfasst:
eine erste Elektrode (110);
eine zweite Elektrode (150), die der ersten Elektrode (110) zugewandt ist; und
eine Zwischenschicht (130), die Folgendes umfasst:
eine Emissionsschicht (132) zwischen der ersten Elektrode (110) und der zweiten Elektrode (150),
eine Lochtransportschicht (131) zwischen der ersten Elektrode (110) und der Emissionsschicht (132), und
einen Elektronentransportbereich (133) zwischen der Emissionsschicht (132) und der zweiten Elektrode (150), wobei:
die erste Elektrode (110) und die Lochtransportschicht (131) in direktem Kontakt stehen,
die erste Elektrode (110) eine mehrschichtige Struktur aufweist, in der eine erste Schicht (110-1) bis zu einer m-ten Schicht (110-m) eine Ganzzahl von 3 oder mehr ist, nacheinander gestapelt sind,
die m-te Schicht (110-m) aus einem ersten anorganischen Material besteht, nämlich:
ein einziges Material, ausgewählt aus GeO₂ und WO_{X} (2,1≤x≤2,99); oder
ein Mischmaterial aus einer beliebigen Kombination von zwei oder mehr, ausgewählt aus der Gruppe bestehend aus ln₂O₃, GeO₂, SnO₂, MoO₃, und WO_{X},
wobei ein Absolutwert der Austrittsarbeit des ersten anorganischen Materials größer oder gleich dem Absolutwert des Energieniveaus des höchsten besetzten Molekülorbitals (HOMO) der Lochtransportschicht (131) ist,
der Absolutwert eines HOMO-Energieniveaus der Lochtransportschicht (131) 5,15 eV oder weniger beträgt,
die Lochtransportschicht (131) keinen p-Dotierstoff umfasst,
wobei die m-te Schicht eine Schicht ist, die der zweiten Elektrode aus den ersten bis m-ten nacheinander gestapelten Schichten am nächsten liegt,
wobei das HOMO-Energieniveau der Lochtransportschicht unter Verwendung zyklischer Voltammetrie, wie in der Beschreibung ausführlich beschrieben, bestimmt wird, und
wobei die Austrittsarbeit des ersten anorganischen Materials durch ultraviolette Photoelektronenspektroskopie bestimmt wird, wie in der Beschreibung ausführlich beschrieben.

2. Lichtemittierende Vorrichtung (10) nach Anspruch 1, wobei:
i) m 3 ist, die erste Schicht (110-1) ITO umfasst, die zweite Schicht Ag umfasst und die dritte Schicht das erste anorganische Material umfasst,
ii) m 3 ist, die erste Schicht (110-1) und die dritte Schicht jeweils aus dem ersten anorganischen Material bestehen, und die zweite Schicht Ag umfasst, oder
iii) m 4 ist, die erste (110-1) und dritte Schicht jeweils ITO umfassen, die zweite Schicht Ag umfasst, und die vierte Schicht aus dem ersten anorganischen Material besteht.

3. Lichtemittierende Vorrichtung (10) nach einem der Anspruch 1 oder Anspruch 2, wobei:
der Absolutwert der Austrittsarbeit des ersten anorganischen Materials 5,20 eV oder mehr beträgt.

4. Lichtemittierende Vorrichtung (10) nach einem der Ansprüche 1 bis 3, wobei:
WO_{X};
ein Mischmaterial bestehend aus In₂O_{3, Ge}O₂ und SnO₂ ist; oder
ein Mischmaterial, in dem ln₂O₃ mit einer Konzentration von 5 Gew.-% oder weniger in mindestens einem ausgewählt aus SnO₂, MoO₃ und WO_{X} ist.

5. Lichtemittierende Vorrichtung (10) nach einem der Ansprüche 1 bis 4, wobei die m-te Schicht (110-m) und die Lochtransportschicht (131) einen ohmschen Kontakt herstellen.

6. Lichtemittierende Vorrichtung (10) nach einem der Ansprüche 1 bis 5, die weiter eine Elektronensperrschicht zwischen der Lochtransportschicht (131) und der Emissionsschicht (132) umfasst, wobei optional:
ein Absolutwert eines HOMO-Energieniveaus der Elektronensperrschicht gleich oder größer als ein Absolutwert eines HOMO-Energieniveaus der Emissionsschicht (132) und gleich oder kleiner als ein Absolutwert des HOMO-Energieniveaus der Lochtransportschicht (131) ist.

7. Lichtemittierende Vorrichtung (10) nach einem der Ansprüche 1 bis 6, wobei der Elektronentransportbereich (133) eine Pufferschicht (210), eine Lochsperrschicht, eine Elektronensteuerschicht, eine Elektronentransportschicht, eine Elektroneninjektionsschicht oder eine Kombination davon umfasst.

8. Lichtemittierende Vorrichtung (10) nach Anspruch 7, wobei der Elektronentransportbereich (133) eine Lochsperrschicht, eine Elektronentransportschicht und eine Elektroneninjektionsschicht umfasst, die nacheinander zwischen der Emissionsschicht (132) und der zweiten Elektrode (150) eingerichtet sind, wobei optional:
ein Absolutwert eines HOMO-Energieniveaus der Lochsperrschicht gleich oder kleiner als ein Absolutwert eines HOMO-Energieniveaus der Emissionsschicht (132) und gleich oder kleiner als ein Absolutwert eines HOMO-Energieniveaus der Elektronentransportschicht ist.

9. Lichtemittierende Vorrichtung (10) nach einem der Ansprüche 1 bis 8, wobei:
(i) die Emissionsschicht (132) einen Wirt und einen Dotierstoff umfasst, und der Dotierstoff einen phosphoreszierenden Dotierstoff, einen fluoreszierenden Dotierstoff oder eine beliebige Kombination davon umfasst,
die Emissionsschicht (132) Quantenpunkte umfasst, oder
die Emissionsschicht (132) ein Material mit verzögerter Fluoreszenz umfasst und das Material mit verzögerter Fluoreszenz als Wirt oder Dotierstoff in der Emissionsschicht (132) fungiert, und/oder
(ii) die erste Elektrode (110) eine Anode ist, und
die zweite Elektrode (150) eine Kathode ist.

10. Lichtemittierende Vorrichtung (10) nach einem der Ansprüche 1 bis 9, wobei:
(i) die Lichtemittierende Vorrichtung (10) weiter mindestens eine einer ersten Deckschicht außerhalb der ersten Elektrode (110) und/oder einer zweiten Deckschicht außerhalb der zweiten Elektrode (150) umfasst,
wobei sowohl die erste als auch die zweite Deckschicht ein Material umfasst, das einen Brechungsindex von 1,6 oder mehr bei einer Wellenlänge von 589 nm aufweist; und/oder
(ii) die Zwischenschicht (130) Folgendes umfasst:
zwei oder mehr lichtemittierende Einheiten, die nacheinander zwischen der ersten Elektrode (110) und der zweiten Elektrode (150) gestapelt sind; und
eine oder mehrere Ladungserzeugungsschichten zwischen je zwei benachbarten lichtemittierenden Einheiten unter den zwei oder mehr lichtemittierenden Einheiten.

11. Elektronische Einrichtung, die die lichtemittierende Vorrichtung (10) nach einem der Ansprüche 1 bis 10 umfasst.

12. Elektronische Einrichtung nach Anspruch 11, die weiter Folgendes umfasst:
(i) einen Dünnschichttransistor (TFT),
wobei der Dünnschichttransistor (TFT) eine Source-Elektrode (260) und eine Drain-Elektrode (270) umfasst, und
die erste Elektrode (110) der lichtemittierenden Vorrichtung (10) elektrisch mindestens mit einer der Source-Elektrode (260) oder der Drain-Elektrode (270) des Dünnschichttransistors (TFT) verbunden ist; und/oder
(ii) einen Farbfilter, eine Farbumwandlungsschicht, eine Touchscreen-Schicht, eine Polarisationsschicht oder eine Kombination davon.

## Revendications

1. Dispositif électroluminescent (10) comprenant :
une première électrode (110) ;
une seconde électrode (150) faisant face à la première électrode (110), et
une couche intermédiaire (130) comprenant :
une couche d'émission (132) entre la première électrode (110) et la seconde électrode (150),
une couche de transport de trous (131) entre la première électrode (110) et la couche d'émission (132), et
une région de transport d'électrons (133) entre la couche d'émission (132) et la seconde électrode (150), dans lequel :
la première électrode (110) et la couche de transport de trous (131) sont en contact direct,
la première électrode (110) présente une structure multicouche, dans laquelle une première couche (110-1) à une m^{ième} couche (110-m), m est un entier égal à 3 ou plus, sont empilées séquentiellement,
la m^{ième} couche (110-m) est constituée d'un premier matériau inorganique, qui est :
un seul matériau sélectionné parmi GeO₂ et WO_{X} (2,1 ≤ x ≤ 2,99) ; ou
un matériau mixte d'une quelconque combinaison de deux ou plus choisis dans le groupe constitué de ln₂O₃, GeO₂, SnO₂, MoO₃ et WO_{X},
une valeur absolue d'un travail de sortie du premier matériau inorganique est supérieure ou égale à une valeur absolue d'un niveau d'énergie de l'orbitale moléculaire occupée d'énergie la plus élevée (HOMO) de la couche de transport de trous (131),
la valeur absolue d'un niveau d'énergie HOMO de la couche de transport de trous (131) est de 5,15 eV ou moins,
la couche de transport de trous (131) ne comprend pas de dopant de type p,
dans lequel la m^{ième} couche est une couche la plus proche de la seconde électrode parmi les première à m^{ième} couches empilées séquentiellement,
dans lequel le niveau d'énergie HOMO de la couche de transport de trous est déterminé à l'aide d'une voltampérométrie cyclique comme détaillé dans la description, et
dans lequel le travail de sortie du premier matériau inorganique est déterminé par spectroscopie photoélectronique UV comme détaillé dans la description.

2. Dispositif électroluminescent (10) selon la revendication 1, dans lequel :
i) m est 3, la première couche (110-1) comprend de l'ITO, la deuxième couche comprend de l'Ag, et la troisième couche est constituée du premier matériau inorganique,
ii) m est 3, chacune de la première couche (110-1) et de la troisième couche est constituée du premier matériau inorganique, et la deuxième couche comprend de l'Ag, ou
iii) m est 4, chacune de la première (110-1) et de la troisième couche comprend de l'ITO, la deuxième couche comprend de l'Ag, et la quatrième couche est constituée du premier matériau inorganique.

3. Dispositif électroluminescent (10) selon la revendication 1 ou la revendication 2, dans lequel :
la valeur absolue du travail de sortie du premier matériau inorganique est de 5,20 eV ou plus.

4. Dispositif électroluminescent (10) selon l'une quelconque des revendications 1 à 3, dans lequel le premier matériau inorganique est :
WO_{X} ;
un matériau mixte constitué d'In₂O₃, de GeO₂ et de SnO₂ ; ou
un matériau mixte dans lequel l'ln₂O₃ est dopé avec une concentration de 5 % en poids ou moins d'au moins un choisi parmi SnO₂, MoO₃ et WO_{X}.

5. Dispositif électroluminescent (10) selon l'une quelconque des revendications 1 à 4, dans lequel la m^{ième} couche (110-m) et la couche de transport de trous (131) forment un contact ohmique.

6. Dispositif électroluminescent (10) selon l'une quelconque des revendications 1 à 5, comprenant en outre une couche de blocage d'électrons entre la couche de transport de trous (131) et la couche d'émission (132), optionnellement dans lequel :
une valeur absolue d'un niveau d'énergie HOMO de la couche de blocage d'électrons est égale ou supérieure à une valeur absolue d'un niveau d'énergie HOMO de la couche d'émission (132), et est égale ou inférieure à une valeur absolue d'un niveau d'énergie HOMO de la couche de transport de trous (131).

7. Dispositif électroluminescent (10) selon l'une quelconque des revendications 1 à 6, dans lequel la région de transport d'électrons (133) comprend une couche tampon (210), une couche de blocage de trous, une couche de contrôle d'électrons, une couche de transport d'électrons, une couche d'injection d'électrons ou une quelconque combinaison de celles-ci.

8. Dispositif électroluminescent (10) selon la revendication 7, dans lequel la région de transport d'électrons (133) comprend une couche de blocage de trous, une couche de transport d'électrons et une couche d'injection d'électrons, qui sont agencées séquentiellement entre la couche d'émission (132) et la seconde électrode (150), optionnellement dans lequel :
une valeur absolue d'un niveau d'énergie HOMO de la couche de blocage de trous est égale ou inférieure à une valeur absolue d'un niveau d'énergie HOMO de la couche d'émission (132), et est égale ou inférieure à une valeur absolue d'un niveau d'énergie HOMO de la couche de transport d'électrons.

9. Dispositif électroluminescent (10) selon l'une quelconque des revendications 1 à 8, dans lequel :
(i) la couche d'émission (132) comprend un hôte et un dopant, et le dopant comprend un dopant phosphorescent, un dopant fluorescent ou une quelconque combinaison de ceux-ci,
la couche d'émission (132) comprend des points quantiques, ou
la couche d'émission (132) comprend un matériau à fluorescence retardée, et le matériau à fluorescence retardée fonctionne comme un hôte ou un dopant dans la couche d'émission (132) ; et/ou
(ii) la première électrode (110) est une anode, et
la seconde électrode (150) est une cathode.

10. Dispositif électroluminescent (10) selon l'une quelconque des revendications 1 à 9, dans lequel :
(i) le dispositif électroluminescent (10) comprend en outre au moins une parmi une première couche de recouvrement à l'extérieur de la première électrode (110) et une seconde couche de recouvrement à l'extérieur de la seconde électrode (150),
dans lequel chacune de la première couche de recouvrement et de la seconde couche de recouvrement comprend un matériau présentant un indice de réfraction de 1,6 ou plus à une longueur d'onde de 589 nm ; et/ou
(ii) la couche intermédiaire (130) comprend :
deux unités électroluminescentes ou plus empilées séquentiellement entre la première électrode (110) et la seconde électrode (150) ; et
une ou plusieurs couches de génération de charge entre deux unités électroluminescentes voisines parmi les deux unités électroluminescentes ou plus.

11. Appareil électronique comprenant le dispositif électroluminescent (10) selon l'une quelconque des revendications 1 à 10.

12. Appareil électronique selon la revendication 11, comprenant en outre :
(i) un transistor à couches minces (TFT),
dans lequel le transistor à couches minces (TFT) comprend une électrode source (260) et une électrode drain (270), et
la première électrode (110) du dispositif électroluminescent (10) est connectée électriquement à au moins une parmi l'électrode source (260) et l'électrode drain (270) du transistor à couches minces (TFT) ; et/ou
(ii) un filtre de couleur, une couche de conversion de couleur, une couche d'écran tactile, une couche polarisante, ou une quelconque combinaison de ceux-ci.
